# EUROPEAN PATENT APPLICATION

(11) **EP 4 589 659 A1**
(43) Date of publication of application: **23.07.2025**
(21) Application number: 23865084.0
(22) Date of filing: 24.07.2023
(51) Int. Cl.: H01L 27/146, H04N 25/70

(54) **IMAGING DEVICE AND ELECTRONIC APPARATUS**

(30) Priority: 15.09.2022 JP 2022146955
(71) Applicant: Sony Semiconductor Solutions Corporation, Atsugi-shi, Kanagawa 243-0014 (JP)
(72) Inventor: TAKAHASHI, Seiki, Atsugi-shi, Kanagawa 243-0014 (JP); NOUDO, Shinichiro, Atsugi-shi, Kanagawa 243-0014 (JP); WATANABE, Maho, Atsugi-shi, Kanagawa 243-0014 (JP); IKEHARA, Shigehiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/027050
(87) International publication number: WO 2024/057724

(57) **Abstract**

An isolation ratio between a plurality of sub-pixels included in a pixel is further improved.

An imaging device including a semiconductor substrate including a photoelectric conversion unit provided for each of pixels arranged two-dimensionally and a pixel isolation unit that isolates the photoelectric conversion units from each other, a color filter and an on-chip lens provided for each of the pixels on one surface of the semiconductor substrate, an inter-filter isolation unit provided to include a low refractive index material having a refractive index lower than a refractive index of the color filter between the color filters and isolate the color filter for each of the pixels, and a sub-pixel isolation unit that isolates the photoelectric conversion units of the pixels including a plurality of sub-pixels for each of the sub-pixels.

## Description

### TECHNICAL FIELD

The present disclosure relates to an imaging device and an electronic device.

### BACKGROUND ART

As an imaging device used for a digital camera or a video camera, a charge coupled device (CCD) image sensor or a complementary metal oxide semiconductor (CMOS) image sensor is known.

In these image sensors, in order to suppress crosstalk between pixels, it has been studied to form a gap between color filters provided for each pixel. For example, Patent Document 1 below discloses forming a gap by closing an upper opening of a trench formed between color filters with a low-coverage film.

### CITATION LIST

### PATENT DOCUMENT

Patent Document 1: U.S. Patent Application Publication No. 2019/0157329

### SUMMARY OF THE INVENTION

### PROBLEMS TO BE SOLVED BY THE INVENTION

However, in the image sensor disclosed in Patent Document 1 described above, crosstalk between sub-pixels in a pixel (for example, a pixel for phase difference detection or the like) including a plurality of sub-pixels has not been particularly studied.

Therefore, the present disclosure proposes a new and improved imaging device and electronic device capable of further improving an isolation ratio between a plurality of sub-pixels included in a pixel.

### SOLUTIONS TO PROBLEMS

According to the present disclosure, there is provided an imaging device including a semiconductor substrate including a photoelectric conversion unit provided for each of pixels arranged two-dimensionally and a pixel isolation unit that isolates the photoelectric conversion units from each other, a color filter and an on-chip lens provided for each of the pixels on one surface of the semiconductor substrate, an inter-filter isolation unit provided to include a low refractive index material having a refractive index lower than a refractive index of the color filter between the color filters and isolate the color filter for each of the pixels, and a sub-pixel isolation unit that isolates the photoelectric conversion units of the pixels including a plurality of sub-pixels for each of the sub-pixels.

Furthermore, according to the present disclosure, there is provided an electronic device including an imaging device, in which the imaging device includes a semiconductor substrate including a photoelectric conversion unit provided for each of pixels arranged two-dimensionally and a pixel isolation unit that isolates the photoelectric conversion units from each other, a color filter and an on-chip lens provided for each of the pixels on one surface of the semiconductor substrate, an inter-filter isolation unit provided to include a low refractive index material having a refractive index lower than a refractive index of the color filter between the color filters and isolate the color filter for each of the pixels, and a sub-pixel isolation unit that isolates the photoelectric conversion units of the pixels including a plurality of sub-pixels for each of the sub-pixels.

### BRIEF DESCRIPTION OF DRAWINGS

Fig. 1 is a schematic diagram illustrating an overall configuration of an imaging device.
Fig. 2 is a longitudinal cross-sectional view illustrating a cross-sectional configuration of a pixel unit according to a configuration example of a first embodiment.
Fig. 3 is a plan view illustrating an example of planar arrangement of sub-pixel isolation units in the pixel unit.
Fig. 4 is a plan view illustrating an example of planar arrangement of sub-pixel isolation units in the pixel unit.
Fig. 5 is a plan view illustrating an example of planar arrangement of sub-pixel isolation units in the pixel unit.
Fig. 6 is a plan view illustrating an example of planar arrangement of sub-pixel isolation units in the pixel unit.
Fig. 7 is a plan view illustrating an example of planar arrangement of sub-pixel isolation units in the pixel unit.
Fig. 8 is a longitudinal cross-sectional view illustrating a cross-sectional configuration of a pixel unit according to a modification of the first embodiment.
Fig. 9 is a plan view illustrating an example of planar arrangement of sub-pixel isolation units in the pixel unit.
Fig. 10 is a plan view illustrating an example of planar arrangement of sub-pixel isolation units in the pixel unit.
Fig. 11 is a plan view illustrating an example of planar arrangement of sub-pixel isolation units in the pixel unit.
Fig. 12 is a longitudinal cross-sectional view illustrating a step of manufacturing the pixel unit according to the first embodiment.
Fig. 13 is a longitudinal cross-sectional view illustrating a step of manufacturing the pixel unit according to the first embodiment.
Fig. 14 is a longitudinal cross-sectional view illustrating a step of manufacturing the pixel unit according to the first embodiment.
Fig. 15 is a longitudinal cross-sectional view illustrating a step of manufacturing the pixel unit according to the first embodiment.
Fig. 16A is a plan view illustrating an example of planar arrangement of a resist layer remaining after entire exposure.
Fig. 16B is a plan view illustrating an example of planar arrangement of the resist layer remaining after entire exposure.
Fig. 17 is a longitudinal cross-sectional view illustrating a step of manufacturing the pixel unit according to the configuration example of the first embodiment.
Fig. 18 is a longitudinal cross-sectional view illustrating a step of manufacturing the pixel unit according to the configuration example of the first embodiment.
Fig. 19 is a longitudinal cross-sectional view illustrating a step of manufacturing the pixel unit according to the configuration example of the first embodiment.
Fig. 20 is a longitudinal cross-sectional view illustrating a step of manufacturing the pixel unit according to the configuration example of the first embodiment.
Fig. 21 is a longitudinal cross-sectional view illustrating a step of manufacturing the pixel unit according to the configuration example of the first embodiment.
Fig. 22 is a longitudinal cross-sectional view illustrating a step of manufacturing the pixel unit according to the configuration example of the first embodiment.
Fig. 23 is a longitudinal cross-sectional view illustrating a step of manufacturing the pixel unit according to the configuration example of the first embodiment.
Fig. 24 is a longitudinal cross-sectional view illustrating a step of manufacturing the pixel unit according to the configuration example of the first embodiment.
Fig. 25 is a longitudinal cross-sectional view illustrating a step of manufacturing the pixel unit according to the configuration example of the first embodiment.
Fig. 26 is a longitudinal cross-sectional view illustrating a step of manufacturing the pixel unit according to the configuration example of the first embodiment.
Fig. 27 is a longitudinal cross-sectional view illustrating a step of manufacturing the pixel unit according to the configuration example of the first embodiment.
Fig. 28 is a longitudinal cross-sectional view illustrating a step of manufacturing the pixel unit according to the configuration example of the first embodiment.
Fig. 29 is a longitudinal cross-sectional view illustrating a step of manufacturing the pixel unit according to the configuration example of the first embodiment.
Fig. 30 is a longitudinal cross-sectional view illustrating a step of manufacturing the pixel unit according to the configuration example of the first embodiment.
Fig. 31 is a longitudinal cross-sectional view illustrating a step of manufacturing the pixel unit according to the configuration example of the first embodiment.
Fig. 32 is a longitudinal cross-sectional view illustrating a step of manufacturing the pixel unit according to the modification of the first embodiment.
Fig. 33 is a longitudinal cross-sectional view illustrating a step of manufacturing the pixel unit according to the modification of the first embodiment.
Fig. 34 is a longitudinal cross-sectional view illustrating a step of manufacturing the pixel unit according to the modification of the first embodiment.
Fig. 35 is a longitudinal cross-sectional view illustrating a step of manufacturing the pixel unit according to the modification of the first embodiment.
Fig. 36 is a longitudinal cross-sectional view illustrating a step of manufacturing the pixel unit according to the modification of the first embodiment.
Fig. 37 is a longitudinal cross-sectional view illustrating a step of manufacturing the pixel unit according to the modification of the first embodiment.
Fig. 38 is a longitudinal cross-sectional view illustrating a step of manufacturing the pixel unit according to the modification of the first embodiment.
Fig. 39 is a longitudinal cross-sectional view illustrating a step of manufacturing the pixel unit according to the modification of the first embodiment.
Fig. 40 is a longitudinal cross-sectional view illustrating a step of manufacturing the pixel unit according to the modification of the first embodiment.
Fig. 41 is a longitudinal cross-sectional view illustrating a step of manufacturing the pixel unit according to the modification of the first embodiment.
Fig. 42 is a longitudinal cross-sectional view illustrating a step of manufacturing the pixel unit according to the modification of the first embodiment.
Fig. 43 is a longitudinal cross-sectional view illustrating a cross-sectional configuration of a pixel unit according to a configuration example of a second embodiment.
Fig. 44 is a transverse cross-sectional view illustrating a planar configuration in A-AA cross section and B-BB cross section of Fig. 43.
Fig. 45 is a longitudinal cross-sectional view illustrating a cross-sectional configuration of a pixel unit according to a modification of the second embodiment.
Fig. 46 is a transverse cross-sectional view illustrating a planar configuration in A-AA cross section and B-BB cross section of Fig. 45.
Fig. 47 is a plan view illustrating an example of a planar arrangement of low refractive index regions in a pixel divided into two left and right sub-pixels.
Fig. 48 is a plan view illustrating an example of a planar arrangement of low refractive index regions in a pixel divided into two left and right sub-pixels.
Fig. 49 is a plan view illustrating an example of a planar arrangement of low refractive index regions in a pixel divided into two left and right sub-pixels.
Fig. 50 is a plan view illustrating an example of a planar arrangement of low refractive index regions in pixels divided into four sub-pixels in a cross shape.
Fig. 51 is a plan view illustrating an example of a planar arrangement of low refractive index regions in pixels divided into four sub-pixels in a cross shape.
Fig. 52 is a plan view illustrating an example of a planar arrangement of low refractive index regions in pixels divided into four sub-pixels in a cross shape.
Fig. 53 is a block diagram illustrating a configuration example of an electronic device including an imaging device.
Fig. 54 is a block diagram illustrating an example of a schematic configuration of a vehicle control system.
Fig. 55 is an explanatory diagram illustrating an example of installation positions of an outside-vehicle information detection section and an imaging section.

### MODE FOR CARRYING OUT THE INVENTION

Hereinafter, preferred embodiments of the present disclosure will be described in detail with reference to the accompanying drawings. Note that, in the present specification and drawings, components having substantially the same functional configuration are denoted by the same reference signs, and redundant description is omitted.

Note that the description will be given in the following order.
0. Overall Configuration of Imaging Device
1. First Embodiment
1.1. Configuration Example
1.2. Modification
1.3. Manufacturing Method
2. Second Embodiment
2.1. Configuration Example
2.2. Modification
2.3. Planar Configuration of Low Refractive Index Region
3. Electronic Device
4. Application Example

### <0. Overall Configuration of Imaging Device>

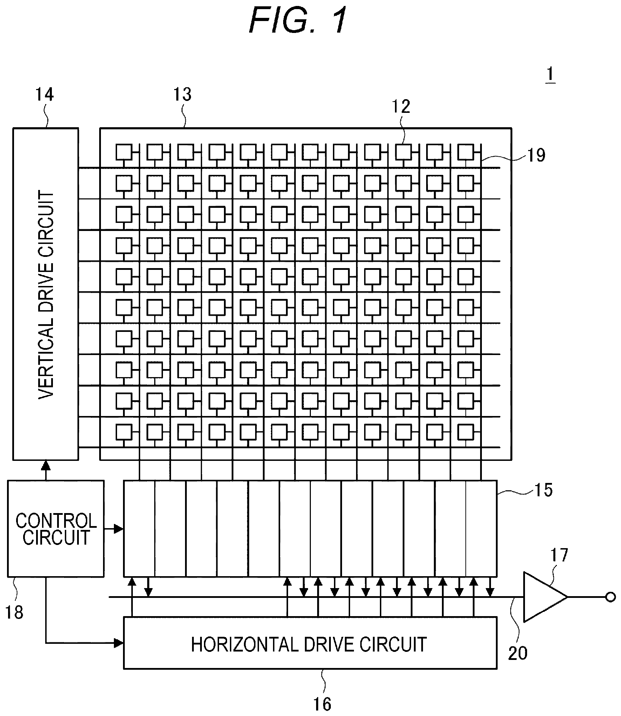

First, an overall configuration of an imaging device according to each embodiment of the present disclosure will be described with reference to Fig. 1. Fig. 1 is a schematic diagram illustrating an overall configuration of an imaging device 1.

As illustrated in Fig. 1, the imaging device 1 includes a pixel unit 13 including a plurality of pixels 12 formed on a semiconductor substrate, a vertical drive circuit 14, column signal processing circuits 15, a horizontal drive circuit 16, an output circuit 17, and a control circuit 18.

The pixel unit 13 includes a plurality of pixels 12 planarly arranged in a matrix on a semiconductor substrate. The pixel 12 includes, for example, a photoelectric conversion unit including a photodiode that photoelectrically converts incident light, and a pixel circuit including a transfer transistor, an amplifier transistor, a selection transistor, and a reset transistor. A signal charge output from the photoelectric conversion unit is converted into a pixel signal by being amplified by the pixel circuit. Note that the pixel circuit need not include the selection transistor.

The pixel 12 may be provided in a shared pixel structure. In the shared pixel structure, a part or all of the pixel circuit is shared among a plurality of adjacent pixels 12. For example, in the plurality of adjacent pixels 12 provided in the shared pixel structure, a pixel circuit including an amplifier transistor, a selection transistor, and a reset transistor at a subsequent stage of the transfer transistor may be shared. That is, in the shared pixel structure, the pixel circuit of the plurality of adjacent pixels 12 includes each photodiode, each transfer transistor, one shared floating diffusion (floating diffusion region: FD), one shared amplifier transistor, one shared selection transistor, and one shared reset transistor.

The control circuit 18 controls operation of each unit of the imaging device 1. More specifically, on the basis of a vertical synchronization signal, a horizontal synchronization signal, and a master clock, the control circuit 18 generates clock signals and control signals on the basis of which the vertical drive circuit 14, the column signal processing circuits 15, the horizontal drive circuit 16, and the like operate. The control circuit 18 can control the operations of the vertical drive circuit 14, the column signal processing circuits 15, and the horizontal drive circuit 16 using the generated clock signals and control signals.

The vertical drive circuit 14 includes, for example, a shift register. The vertical drive circuit 14 drives the pixels 12 row by row by sequentially selectively scanning the pixels 12 row by row in the vertical direction. Thus, the vertical drive circuit 14 can read a pixel signal generated according to a light reception amount of each of the pixels 12 from each of the pixels 12 and supply the pixel signal to the column signal processing circuit 15 via the vertical signal line 19.

The column signal processing circuit 15 is provided for each column of the pixels 12, and performs signal processing such as noise removal on the pixel signals output from the pixels 12. For example, the column signal processing circuit 15 may perform, on the pixel signals output from the pixels 12, correlated double sampling (CDS) processing for removing pattern noise unique to each pixel 12, analog-digital (AD) conversion processing, and the like.

The horizontal drive circuit 16 includes, for example, a shift register. The horizontal drive circuit 16 sequentially outputs horizontal scanning pulses and sequentially selects each of the column signal processing circuits 15 to cause each of the column signal processing circuits 15 to output a pixel signal to the horizontal signal line 20.

The output circuit 17 outputs the pixel signal sequentially supplied from each of the column signal processing circuits 15 via the horizontal signal line 20 to the outside of the imaging device 1. For example, the output circuit 17 may perform various types of digital signal processing such as buffering, black level adjustment, or column variation correction on the pixel signal supplied from each of the column signal processing circuits 15, and output the pixel signal after the signal processing to the outside of the imaging device 1.

The imaging device 1 having the above configuration is a so-called column AD type complementary MOS (CMOS) image sensor in which the column signal processing circuit 15 that performs the CDS processing and the AD conversion processing is provided for each column of the pixels 12. Hereinafter, a specific configuration of the pixel unit 13 included in the above-described imaging device 1 will be described separately for the first embodiment and the second embodiment.

### <1. First Embodiment>

### (1.1. Configuration Example)

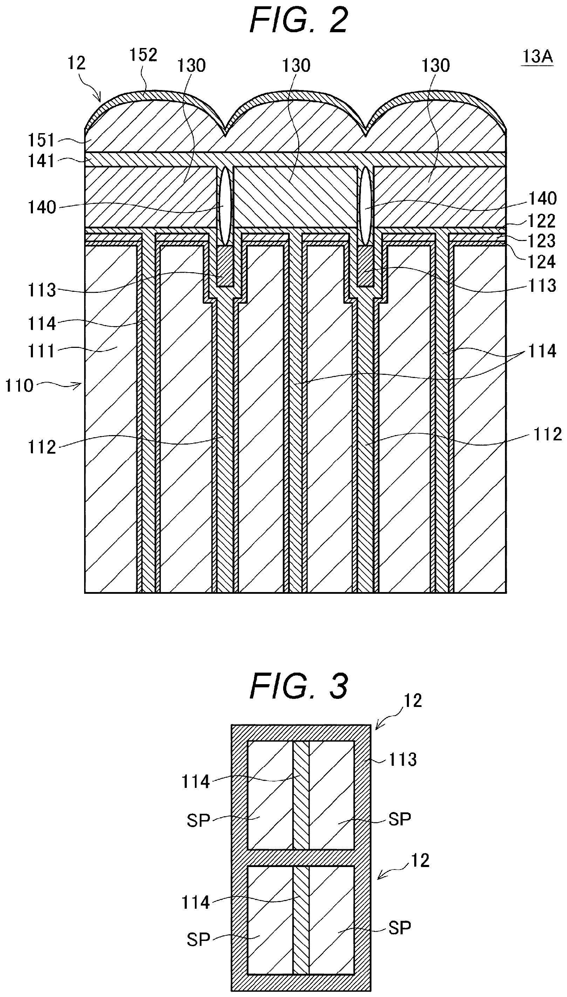

A configuration example of the pixel unit 13 according to the first embodiment of the present disclosure will be described with reference to Fig. 2. Fig. 2 is a longitudinal cross-sectional view illustrating a cross-sectional configuration of the pixel unit 13A according to a configuration example of the first embodiment.

As illustrated in Fig. 2, the pixel unit 13A includes a semiconductor substrate 110 in which photoelectric conversion units 111 are provided, a dielectric layer 122, a reflection control layer 123, a fixed charge layer 124, a color filter 130, an insulating layer 141, an on-chip lens 151, and an antireflection film 152. The pixels 12 included in the pixel unit 13A are pixels each having a plurality of sub-pixels in which light receiving regions are divided with respect to one color filter 130 and one on-chip lens 151. Such a pixel 12 is used, for example, as a phase difference pixel that detects the distance to the subject on the basis of a pixel signal obtained in each of the sub-pixels.

The semiconductor substrate 110 is, for example, a substrate having a thickness of 1 µm to 6 µm and constituted by silicon (Si). In the semiconductor substrate 110, a photoelectric conversion unit 111 that generates a signal charge corresponding to the amount of received incident light is provided for each pixel 12. The photoelectric conversion unit 111 is a photodiode, and is constituted by PN junction between a semiconductor region of a first conductivity type (for example, p-type) and a semiconductor region of a second conductivity type (for example, n-type). For example, the photoelectric conversion unit 111 may be constituted by providing a semiconductor region of the second conductivity type (for example, n-type) inside a well region of the first conductivity type (for example, p-type) for each pixel 12.

The photoelectric conversion units 111 provided for the respective pixels 12 are physically and electrically separated from each other in a pixel isolation unit 112 formed by an insulating material. The pixel isolation unit 112 may include, for example, an insulating material such as silicon oxide (SiOₓ), silicon nitride (SiN), or silicon oxynitride (SiON) extending in a thickness direction of the semiconductor substrate 110 to separate the photoelectric conversion unit 111 in each pixel 12.

Furthermore, the photoelectric conversion unit 111 separated by the pixel isolation unit 112 for each pixel 12 is further physically and electrically separated by a sub-pixel isolation unit 114 for each sub-pixel. The sub-pixel isolation unit 114 is provided by extending an insulating material such as silicon oxide (SiOₓ), silicon nitride (SiN), or silicon oxynitride (SiON) in the thickness direction of the semiconductor substrate 110, for example.

Moreover, a light shielding unit 113 is provided above the pixel isolation unit 112. Specifically, the light shielding unit 113 may be provided so as to be embedded in the pixel isolation unit 112 on the color filter 130 side. For example, the light shielding unit 113 may be constituted by a conductive material such as tungsten (W), aluminum (Al), copper (Cu), titanium nitride (TiN), or polysilicon (poly-Si) capable of shielding light, or may be constituted by an organic resin material containing a carbon black pigment or a titanium black pigment. The light shielding unit 113 can suppress crosstalk between the adjacent pixels 12 by shielding light leaking into the adjacent pixels 12.

The dielectric layer 122 is formed by a dielectric material, and is provided to extend from the pixel isolation unit 112. Specifically, the dielectric layer 122 is provided to extend from an end portion of the pixel isolation unit 112 on the light shielding unit 113 side so as to surround a lower surface and a side surface of the light shielding unit 113. The dielectric layer 122 is further provided along a lower surface of the color filter 130 by extending from the lower surface and the side surface of the light shielding unit 113 to above the semiconductor substrate 110.

The dielectric layer 122 is formed by the same insulating material (that is, the dielectric material) as that of the pixel isolation unit 112, and is formed in the same process as that of the pixel isolation unit 112. For example, the pixel isolation unit 112 and the dielectric layer 122 may be constituted by depositing silicon oxide (SiO₂), silicon nitride (SiN), silicon oxynitride (SiON), or the like using atomic layer deposition (ALD). In such a case, the thickness of the dielectric layer 122 provided along the side surface of the light shielding unit 113 can be at least substantially the same as the thickness of the dielectric layer 122 provided along the lower surface of the light shielding unit 113. Moreover, the thickness of the dielectric layer 122 provided along the lower surface of the color filter 130 can be substantially the same as the thickness of the dielectric layer 122 provided along the side surface and the lower surface of the light shielding unit 113.

However, the thickness of the dielectric layer 122 provided along the side surface of the light shielding unit 113 may be thinner than the thickness of the dielectric layer 122 provided along the lower surface of the light shielding unit 113. In such a case, the pixel unit 13A can further increase the quantum efficiency in the photoelectric conversion unit 111 of the pixel 12 and further suppress the crosstalk between the pixels 12.

The fixed charge layer 124 is formed by a material having a negative fixed charge, and is provided at an interface between the semiconductor substrate 110 and another layer. Specifically, the fixed charge layer 124 may be constituted by a high dielectric material having a negative fixed charge such as hafnium oxide (HfO₂), zirconium oxide (ZrO₂), aluminum oxide (Al₂O₃), tantalum oxide (Ta₂O₅), titanium oxide (TiO₂), magnesium oxide (MgO), yttrium oxide (Y₂O₃), or an oxide of a lanthanoid. The fixed charge layer 124 can suppress generation of a dark current at the interface between the semiconductor substrate 110 and another layer by forming a region in which positive charges are accumulated at the interface with the semiconductor substrate 110 by negative fixed charges.

For example, the fixed charge layer 124 may be provided to extend between the semiconductor substrate 110 and other layers such as the dielectric layer 122 provided on the side surface of the light shielding unit 113, the pixel isolation unit 112 continuous with the dielectric layer 122, and the sub-pixel isolation unit 114. In such a case, the fixed charge layer 124 can suppress generation of dark current between the semiconductor substrate 110 and the dielectric layer 122, the pixel isolation unit 112, and the sub-pixel isolation unit 114 by negative fixed charges.

The reflection control layer 123 is formed by a material having a refractive index higher than the refractive index of the dielectric layer 122 and lower than the refractive index of the semiconductor substrate 110, and is provided between the fixed charge layer 124 on the semiconductor substrate 110 and the dielectric layer 122. For example, the reflection control layer 123 may be provided between the fixed charge layer 124 provided on a surface of the semiconductor substrate 110 and the dielectric layer 122 provided on the lower surface of the color filter 130. Since the reflection control layer 123 can suppress reflection of light at the interface with the dielectric layer 122 or the interface with the semiconductor substrate 110, it is possible to improve the incident efficiency of light on the photoelectric conversion unit 111.

The color filter 130 is provided for each pixel 12 on the dielectric layer 122, and selectively transmits light (for example, red light (R), green light (G), and blue light (B)) in a wavelength band corresponding to each pixel 12. The color filter 130 may be provided in a predetermined RGB array such as a Bayer array, for example.

As an example, the color filter 130 may be a colored filter in which a pigment or a dye is added to a transparent resin that transmits visible light. As another example, the color filter 130 may be a transparent filter formed by a transparent resin that transmits visible light, a neutral density (ND) filter in which carbon black is added to a transparent resin, or the like.

Here, in the pixel unit 13A, the color filter 130, the dielectric layer 122, the reflection control layer 123, and the fixed charge layer 124 are divided for each pixel 12 by the inter-filter isolation unit 140 extending in the thickness direction of the semiconductor substrate 110.

The inter-filter isolation unit 140 includes a low refractive index material having a refractive index lower than the refractive index of the color filter 130, and is provided between the color filters 130, the dielectric layers 122, the reflection control layers 123, and the fixed charge layers 124 respectively provided for the pixels 12. According to this, the inter-filter isolation unit 140 can cause the color filter 130, the dielectric layer 122, the reflection control layer 123, and the fixed charge layer 124 to function as a waveguide in which a high refractive index material is sandwiched between low refractive index materials. Therefore, the inter-filter isolation unit 140 reflects the light traveling to the adjacent pixel 12 at the interface with the color filter 130, so that the incident efficiency of the light on the photoelectric conversion unit 111 can be improved.

The low refractive index material included in the inter-filter isolation unit 140 may be air having a refractive index of approximately 1. In such a case, the inter-filter isolation unit 140 includes a gap containing air and an insulating material covering at least a part of an inner wall of the gap. Note that the insulating material covering at least a part of the inner wall of the gap is, for example, an insulating material that has entered the inside of the gap at the time of forming the insulating layer 141 that seals the gap.

The low refractive index material contained in the inter-filter isolation unit 140 may be other than air, and may be, for example, an inorganic material such as silicon oxide (SiO₂), silicon nitride (SiN), or silicon oxynitride (SiON), may be a resin material such as a styrene resin, an acrylic resin, a styrene-acrylic copolymer resin, or a siloxane resin, or may be a so-called low-k material such as SiOF, SiOC, or porous silica.

The insulating layer 141 is constituted by an insulating material on the color filter 130. For example, the insulating layer 141 may be provided by forming a film of silicon oxide (SiO₂) or the like on the color filter 130 with high coverage.

The on-chip lens 151 is provided for each pixel 12 on the insulating layer 141. The on-chip lens 151 may be constituted by, for example, a resin material such as a styrene resin, an acrylic resin, a styrene-acrylic copolymer resin, or a siloxane resin. The on-chip lens 151 collects the light incident on the pixel 12 on a central portion of the pixel 12, so that the light incident on the pixel 12 can be efficiently incident on the photoelectric conversion unit 111.

Furthermore, the antireflection film 152 may be formed on the surface layer of the on-chip lens 151. The antireflection film 152 is configured as, for example, a dielectric multilayer film. The antireflection film 152 can suppress reflection of light incident on the on-chip lens 151.

Subsequently, a planar arrangement of the sub-pixel isolation unit 114 in the pixel unit 13A will be described with reference to Figs. 3 to 7. Figs. 3 to 7 are plan views illustrating an example of the planar arrangement of the sub-pixel isolation unit 114 in the pixel unit 13A. The sub-pixel isolation unit 114 may be arranged in any planar layout as long as the pixel 12 can be divided into a plurality of sub-pixels SP.

As illustrated in Fig. 3, the sub-pixel isolation unit 114 may divide the pixel 12 into two sub-pixels SP by extending in one direction from the pixel isolation unit 112 at one end to the pixel isolation unit 112 at the other end.

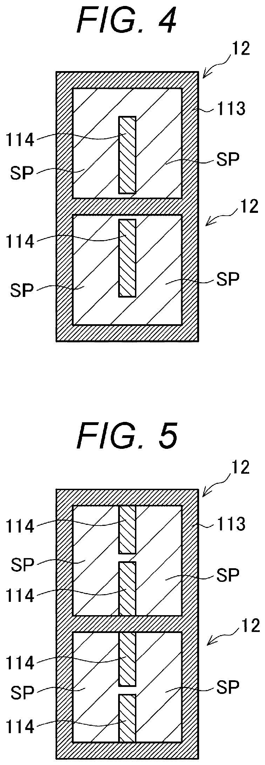

As illustrated in Fig. 4, the sub-pixel isolation unit 114 may be provided in an island shape in the pixel 12 while extending in one direction to divide the pixel 12 into two sub-pixels SP. That is, the sub-pixel isolation unit 114 need not completely separate the photoelectric conversion units 111 of the two sub-pixels SP by not being in contact with the pixel isolation units 112 at one end or both ends.

As illustrated in Fig. 5, the sub-pixel isolation unit 114 may extend in one direction from the pixel isolation unit 112 at one end to the pixel isolation unit 112 at the other end, and may be divided into a plurality of portions separated from each other at the central portion of the pixel 12. In such a case, the sub-pixel isolation unit 114 is not provided at the central portion of the pixel 12. Thus, the sub-pixel isolation unit 114 can avoid scattering the collected incident light at the light collection center in the central portion of the pixel 12. Therefore, the sub-pixel isolation unit 114 can suppress crosstalk between the sub-pixels SP caused by scattering at the light collection center of the pixel 12.

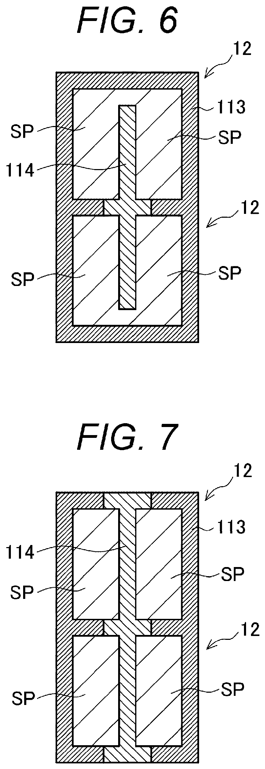

As illustrated in Fig. 6, the sub-pixel isolation unit 114 may be provided across the plurality of pixels 12. Specifically, the sub-pixel isolation unit 114 may be provided to extend in one direction from one pixel 12 to another adjacent pixel 12 across the pixel isolation unit 112 between the adjacent pixels 12. According to this, since the pixel unit 13A can simplify the formation process of the sub-pixel isolation unit 114, the manufacturing cost can be suppressed.

As illustrated in Fig. 7, the sub-pixel isolation unit 114 may be further provided continuously over the plurality of pixels 12. Specifically, the sub-pixel isolation unit 114 may be continuously provided so as to cross the plurality of pixels 12 extending in one direction. That is, the sub-pixel isolation unit 114 may divide each of the plurality of pixels 12 into two sub-pixels SP by extending in one direction over the entire pixel unit 13A. Even in such a case, the pixel unit 13A can simplify the formation process of the sub-pixel isolation unit 114, and thus, can suppress the manufacturing cost.

### (1.2. Modification)

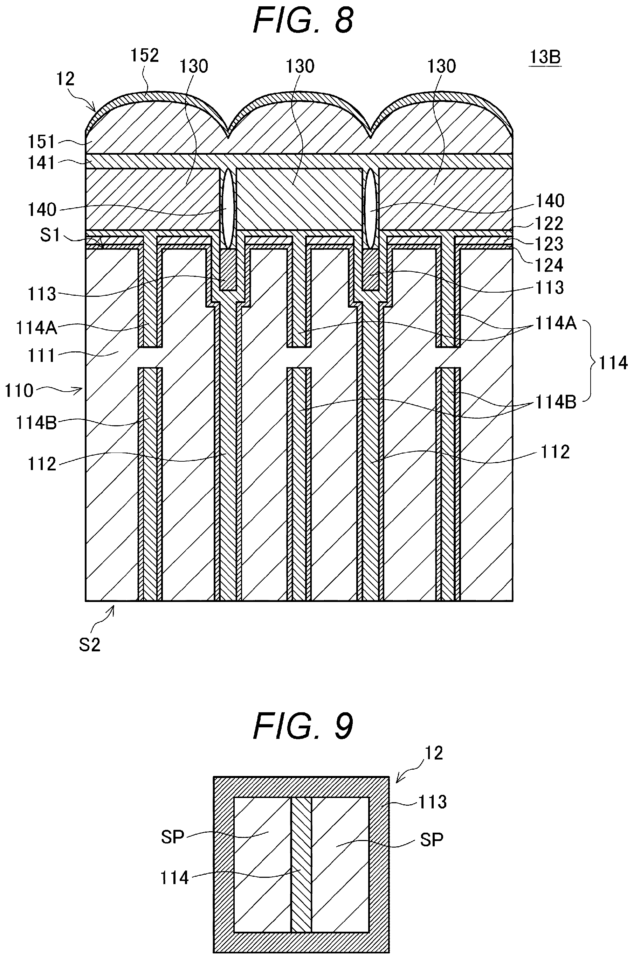

A modification of the pixel unit 13 according to the present embodiment will be described with reference to Fig. 8. Fig. 8 is a longitudinal cross-sectional view illustrating a cross-sectional configuration of a pixel unit 13B according to the modification of the first embodiment.

As illustrated in Fig. 8, the pixel unit 13B includes a semiconductor substrate 110 in which photoelectric conversion units 111 are provided, a dielectric layer 122, a reflection control layer 123, a fixed charge layer 124, a color filter 130, an insulating layer 141, an on-chip lens 151, and an antireflection film 152. The pixel 12 included in the pixel unit 13B is a pixel having a plurality of sub-pixels in which a light receiving region is divided for one color filter 130 and one on-chip lens.

The pixel unit 13B is different from the pixel unit 13A illustrated in Fig. 2 in that the sub-pixel isolation unit 114 is divided in the thickness direction of the semiconductor substrate 110. Specifically, in the pixel unit 13B, the sub-pixel isolation unit 114 is divided into a plurality of portions separated from each other in the thickness direction of the semiconductor substrate 110.

For example, the sub-pixel isolation unit 114 may be divided into a first sub-pixel isolation unit 114A extending in the thickness direction of the semiconductor substrate 110 from the first surface S1 on the side where the color filter 130 is provided, and a second sub-pixel isolation unit 114B extending in the thickness direction of the semiconductor substrate 110 from the second surface S2 on the opposite side of the first surface S1. The first sub-pixel isolation unit 114A is formed by providing an opening in the semiconductor substrate 110 from the first surface S1, and the second sub-pixel isolation unit 114B is formed by providing an opening in the semiconductor substrate 110 from the second surface S2. Even in such a case, the sub-pixel isolation unit 114 can physically and electrically separate the photoelectric conversion unit 111 for each sub-pixel.

The planar arrangement of the sub-pixel isolation units 114 in the pixel unit 13B will be described with reference to Figs. 9 to 11. Figs. 9 to 11 are plan views illustrating an example of the planar arrangement of the sub-pixel isolation units 114 in the pixel unit 13B. The sub-pixel isolation unit 114 may be arranged in any planar layout as long as the pixel 12 can be divided into a plurality of sub-pixels SP.

As illustrated in Fig. 9, the sub-pixel isolation unit 114 may divide the pixel 12 into two sub-pixels SP by extending in one direction from the pixel isolation unit 112 at one end to the pixel isolation unit 112 at the other end.

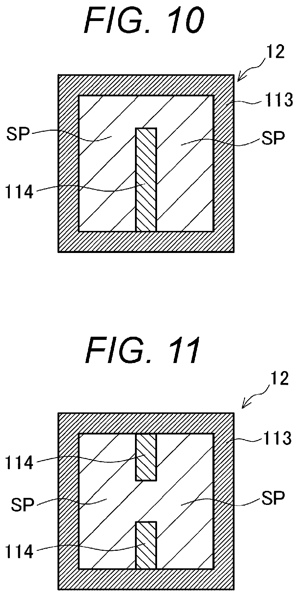

As illustrated in Fig. 10, the sub-pixel isolation unit 114 may be provided in an island shape in the pixel 12 while extending in one direction to divide the pixel 12 into two sub-pixels SP. That is, the sub-pixel isolation unit 114 need not be in contact with the pixel isolation units 112 at one end or both ends, and may not completely separate the photoelectric conversion units 111 of the two sub-pixels SP.

As illustrated in Fig. 11, the sub-pixel isolation unit 114 may extend in one direction from the pixel isolation unit 112 at one end to the pixel isolation unit 112 at the other end, and may be divided into a plurality of portions separated from each other at the central portion of the pixel 12. In such a case, the sub-pixel isolation unit 114 is not provided at the central portion of the pixel 12. Thus, the sub-pixel isolation unit 114 can avoid scattering the collected incident light at the light collection center in the central portion of the pixel 12. Therefore, the sub-pixel isolation unit 114 can suppress crosstalk between the sub-pixels SP caused by scattering at the light collection center of the pixel 12.

### (1.3. Manufacturing Method)

### (Method of Manufacturing Pixel Unit 13A)

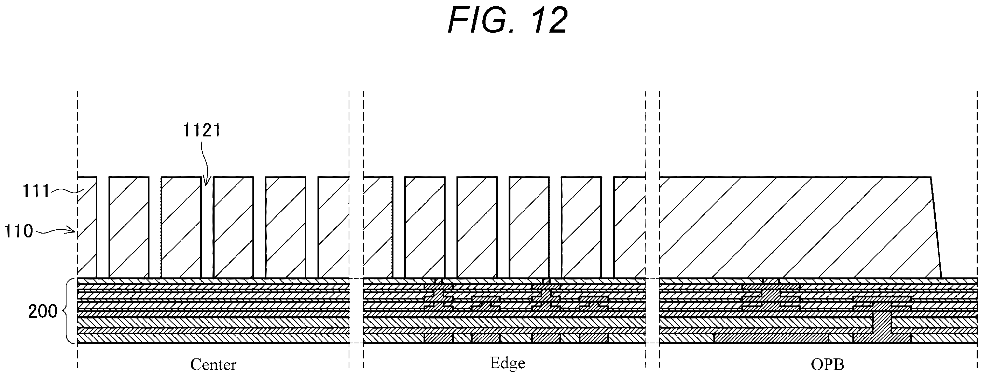

A method of manufacturing the pixel unit 13A according to a configuration example of the first embodiment will be described with reference to Figs. 12 to 31. Figs. 12 to 15 and Figs. 17 to 31 are longitudinal cross-sectional views illustrating steps of manufacturing the pixel unit 13A according to the configuration example of the first embodiment.

Note that, in Figs. 12 to 15 and 17 to 31, "Center" indicates a region on the central side of the pixel unit 13A, and "Edge" indicates a region on a peripheral edge side of the pixel unit 13A. In addition, "OPB" indicates an optically black region provided in the pixel unit 13A. The optically black region is a region for detecting dark noise by the light-shielded photoelectric conversion unit 111.

First, as illustrated in Fig. 12, a circuit layer 200 including a pixel transistor, wiring, and the like and a semiconductor substrate 110 are bonded together, and the bonded semiconductor substrate 110 is etched to form an opening 1121. For example, the opening 1121 may be provided so as to penetrate the semiconductor substrate 110 formed by silicon. Note that an uneven structure for preventing reflection may be formed on the surface of the semiconductor substrate 110 opposite to a surface bonded to the circuit layer 200.

The opening 1121 is a recess in which the pixel isolation unit 112 or the sub-pixel isolation unit 114 is formed in a subsequent process. The opening 1121 may be provided with different widths or depths between the opening 1121 in which the pixel isolation unit 112 is formed and the opening 1121 in which the sub-pixel isolation unit 114 is formed, or may be provided with the same width or depth.

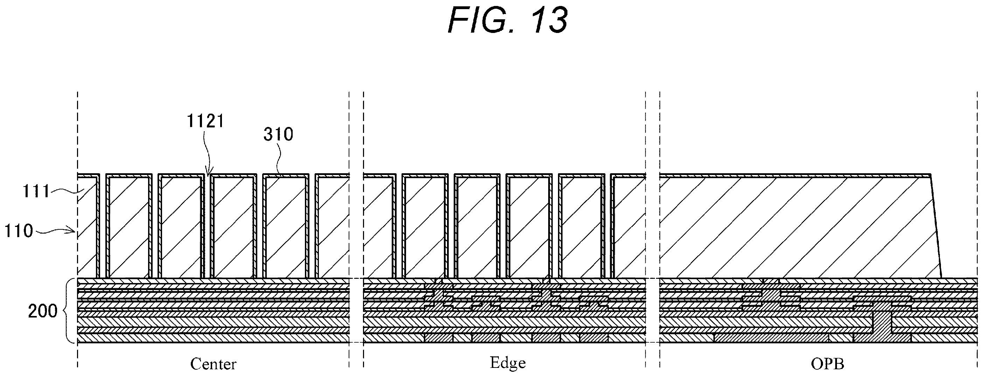

Next, as illustrated in Fig. 13, a protective film 310 is formed on the exposed surface of the semiconductor substrate 110 by ALD. The protective film 310 is formed by, for example, silicon oxide (SiO₂) or the like, and may be formed with a uniform thickness on the exposed surface of the semiconductor substrate 110 including a bottom surface and an inner side surface of the opening 1121.

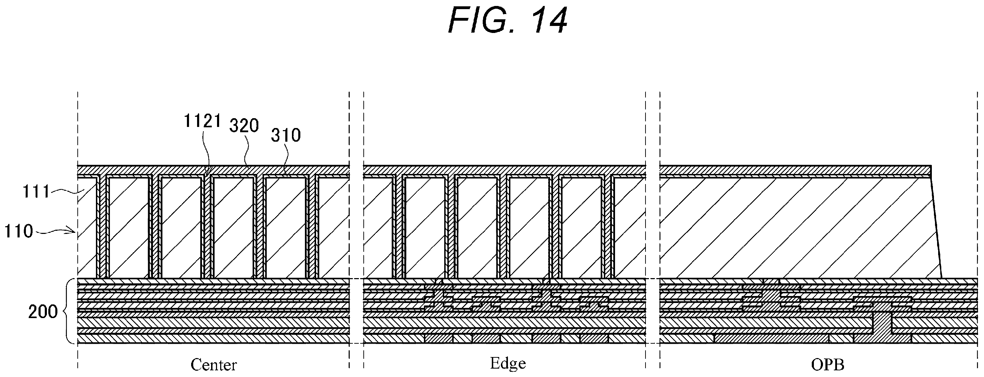

Subsequently, as illustrated in Fig. 14, a resist layer 320 is formed so as to fill the opening 1121 and cover the surface of the semiconductor substrate 110. The resist layer 320 may be, for example, an i-line resist.

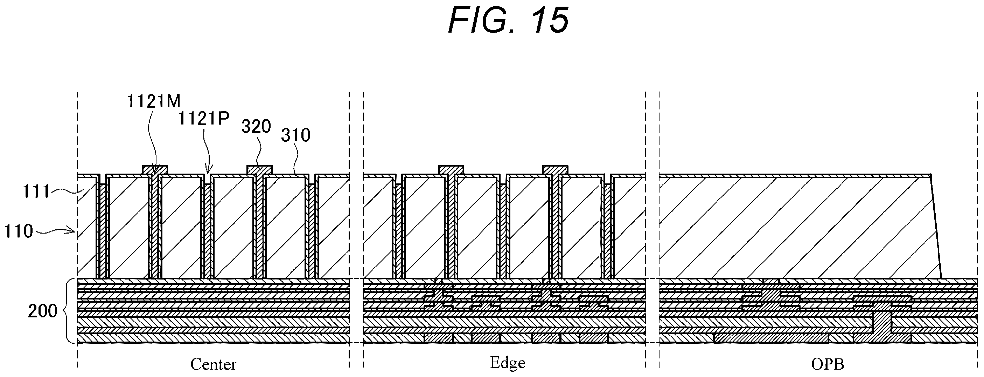

Next, as illustrated in Fig. 15, by exposing the entire surface of the resist layer 320, the resist layer 320 is retracted until the protective film 310 provided on the surface of the semiconductor substrate 110 is exposed. At this time, in an opening 1121P in which the pixel isolation unit 112 is formed, exposure is performed so that the exposed resist layer 320 retreats to the inside of the opening 1121P. On the other hand, in an opening 1121M in which the sub-pixel isolation unit 114 is formed, the exposure is controlled using a hard mask or the like so that the resist layer 320 remains on the protective film 310.

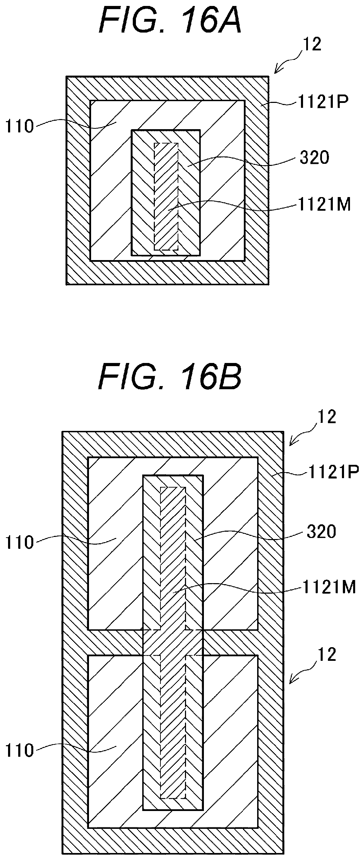

Figs. 16A and 16B are plan views illustrating an example of the planar arrangement of the resist layer 320 remaining after exposure of the entire surface. As illustrated in Figs. 16A and 16B, the resist layer 320 may be exposed to remain in a region covering the opening 1121M in which the sub-pixel isolation unit 114 is formed. For example, it is desirable that the resist layer 320 is exposed so as to leave a region wider than the opening 1121M in consideration of positional deviation in superposition with the opening 1121M.

As illustrated in Fig. 16A, the resist layer 320 may be exposed to remain in a wider rectangular region including the sub-pixel isolation unit 114 provided in an island shape in the pixel 12. Furthermore, as illustrated in Fig. 16B, the resist layer 320 may be exposed so as to remain in a rectangular region across the plurality of pixels 12 so as to include the sub-pixel isolation unit 114 provided across the plurality of pixels 12.

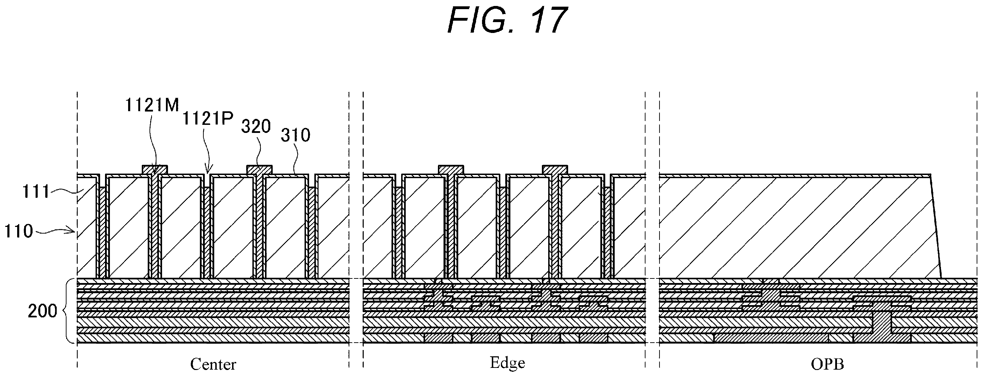

Subsequently, as illustrated in Fig. 17, etching (etch-back) is performed on the entire surface of the semiconductor substrate 110. Thus, a retraction amount of the resist layer 320 in the opening 1121P is controlled to a target depth.

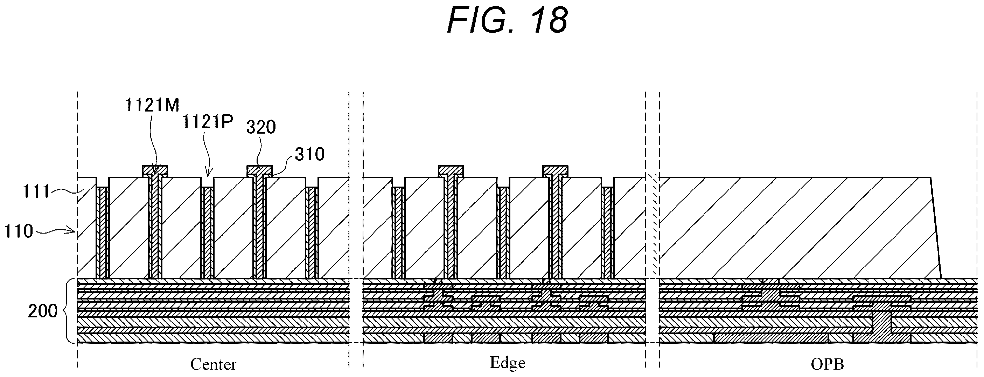

Next, as illustrated in Fig. 18, the protective film 310 not masked by the resist layer 320 is removed by etching with diluted hydrofluoric acid (DHF).

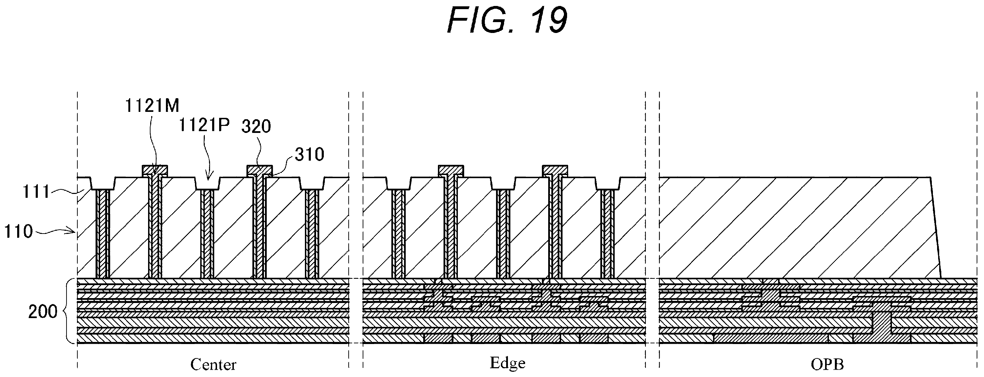

Subsequently, as illustrated in Fig. 19, a region of the semiconductor substrate 110 that is not masked by the protective film 310 and the resist layer 320 is isotropically etched by chemical dry etching (CDE). Thus, the opening width of the upper portion of the opening 1121P is widened.

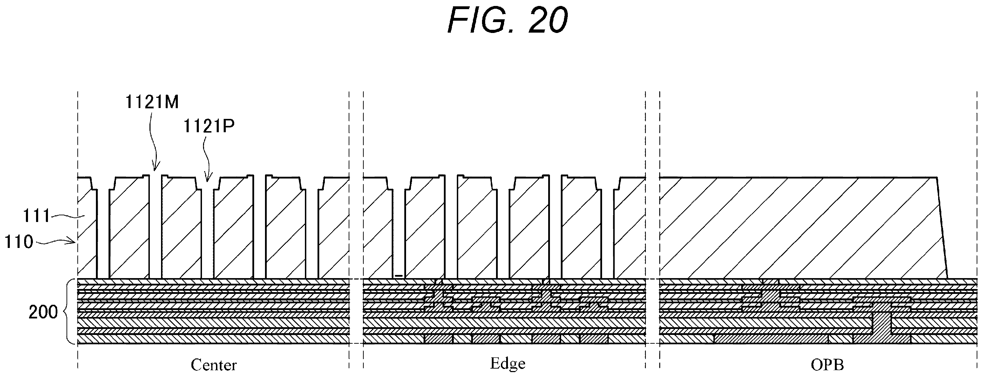

Thereafter, as illustrated in Fig. 20, the protective film 310 and the resist layer 320 are removed. At this time, a step corresponding to the retraction of the surface of the semiconductor substrate 110 by the CDE process illustrated in Fig. 19 is generated in the opening 1121M.

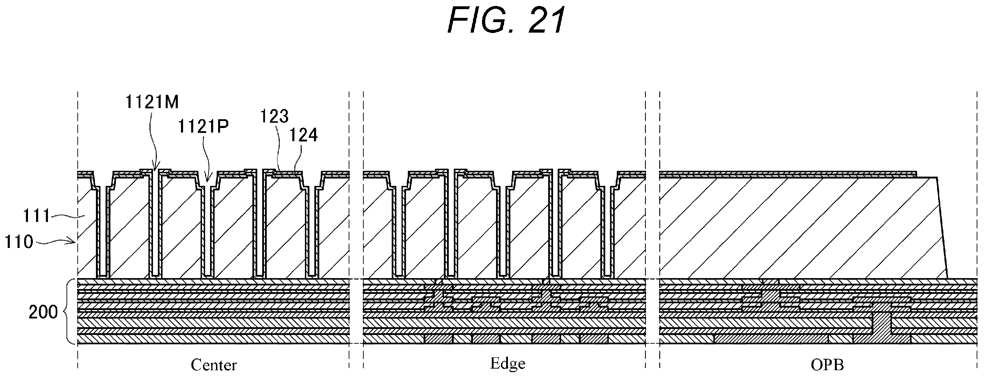

Next, as illustrated in Fig. 21, the fixed charge layer 124 and the reflection control layer 123 are sequentially formed along the shape of the semiconductor substrate 110 by ALD. For example, the fixed charge layer 124 may be formed with a uniform thickness on the exposed surface of the semiconductor substrate 110 including a bottom surface and an inner side surface of the opening 1121P and the opening 1121M. Furthermore, the reflection control layer 123 may be formed only on the fixed charge layer 124 provided on the surface of the semiconductor substrate 110.

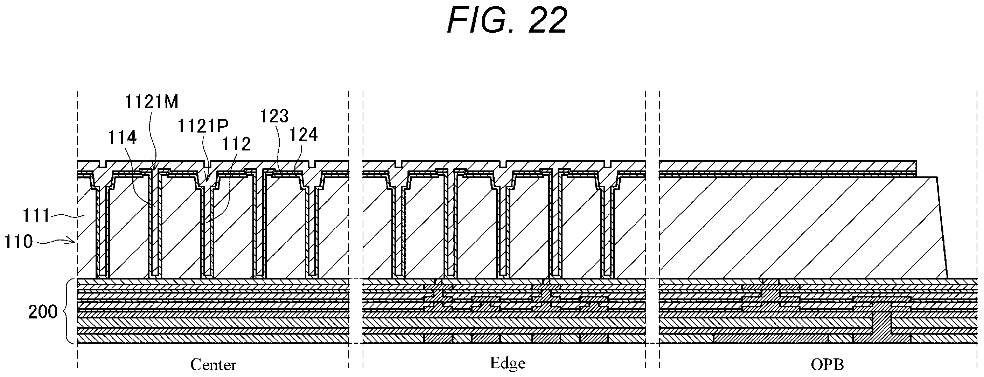

Next, as illustrated in Fig. 22, an insulating material such as SiO₂ is deposited on the fixed charge layer 124 by ALD, whereby the opening 1121P and the opening 1121M are embedded. Thus, the pixel isolation unit 112 is formed inside the opening 1121P, and the sub-pixel isolation unit 114 is formed inside the opening 1121M.

At this time, although the opening 1121M is completely embedded, the opening 1121P is not completely embedded because the opening width is widened. Thus, a recessed structure remains on the pixel isolation unit 112 formed in the opening 1121P. In the recessed structure on the pixel isolation unit 112, the light shielding unit 113 is formed in a subsequent process.

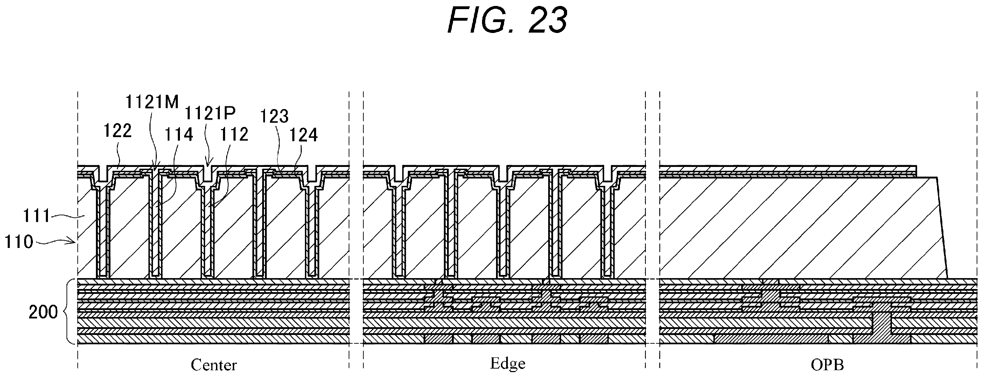

Subsequently, as illustrated in Fig. 23, the thickness of the insulating material on the reflection control layer 123 is controlled by entire surface etching (etch back) by CDE, whereby the dielectric layer 122 is formed. Furthermore, the width and depth of the recessed structure on the pixel isolation unit 112 formed in the opening 1121P are controlled to a desired width and depth by the above-described entire surface etching.

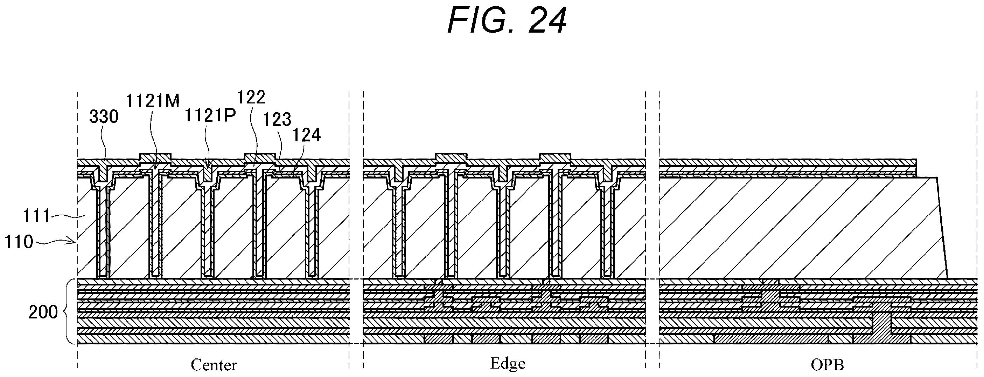

Next, as illustrated in Fig. 24, a light shielding film 330 is formed on the dielectric layer 122 so as to fill the recessed structure on the pixel isolation unit 112 formed in the opening 1121P. The light shielding film 330 may have, for example, a stacked structure of Ti or TiN and W.

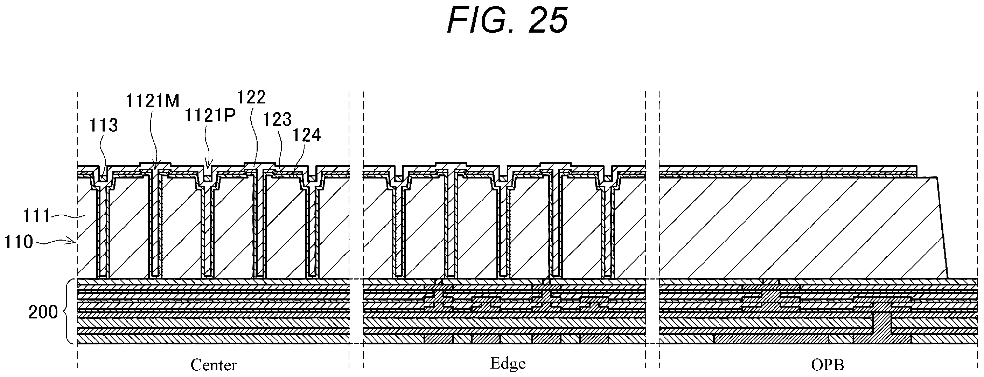

Moreover, as illustrated in Fig. 25, the light shielding film 330 in the region excluding the recessed structure on the pixel isolation unit 112 is removed by using chemical mechanical polishing (CMP) and dry etching in combination. Thus, the light shielding unit 113 is formed on the pixel isolation unit 112 formed in the opening 1121P.

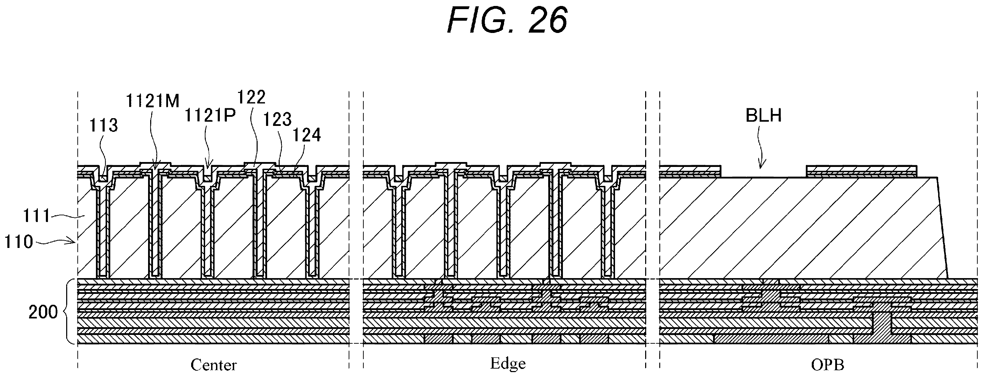

Subsequently, as illustrated in Fig. 26, a part of the fixed charge layer 124, the reflection control layer 123, and the dielectric layer 122 in the optically black region OPB is removed to form an opening BLH. Note that a protective film formed by an insulating material may be formed on the light shielding unit 113 in order to protect the light shielding unit 113 from a subsequent process.

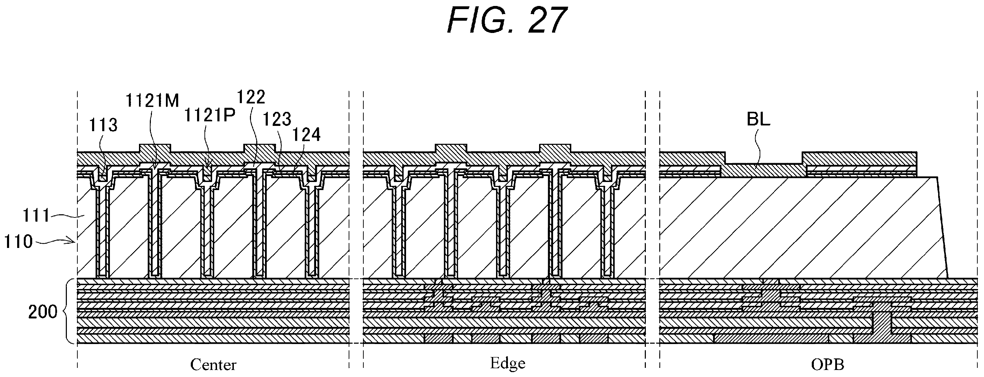

Next, as illustrated in Fig. 27, a light shielding film BL is formed on the entire surface of the semiconductor substrate 110 so as to fill the opening BLH. The light shielding film PBL may have a stacked structure of TiN, Ti, and W, for example.

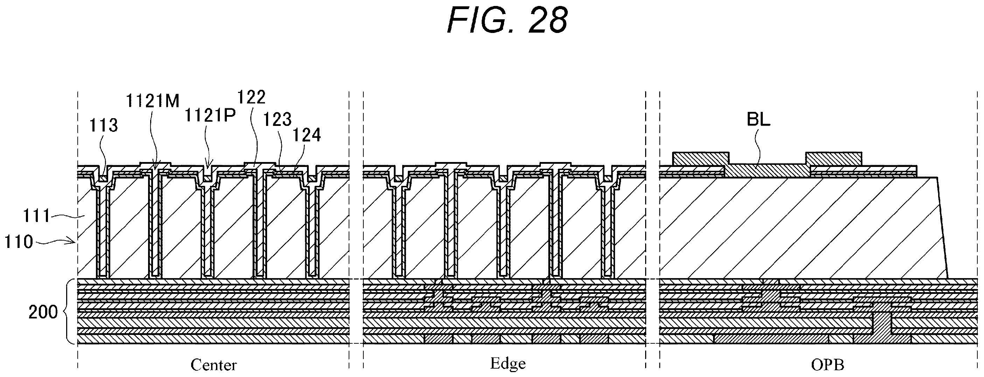

Thereafter, as illustrated in Fig. 28, the light shielding film BL provided on effective pixels excluding the optically black region OPB is removed by using chemical mechanical polishing (CMP) and dry etching in combination. Thus, pixels capable of detecting dark noise are formed in the optically black region OPB.

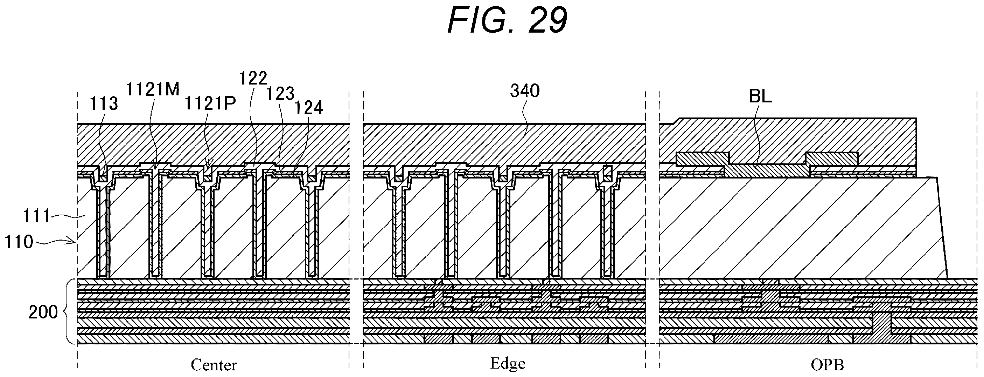

Next, as illustrated in Fig. 29, a temporary wall portion 340 is formed on the semiconductor substrate 110 by chemical vapor deposition (CVD). The temporary wall portion 340 is formed by amorphous silicon (a-Si) or the like, and functions as a guide when the color filter 130 is formed in a subsequent process.

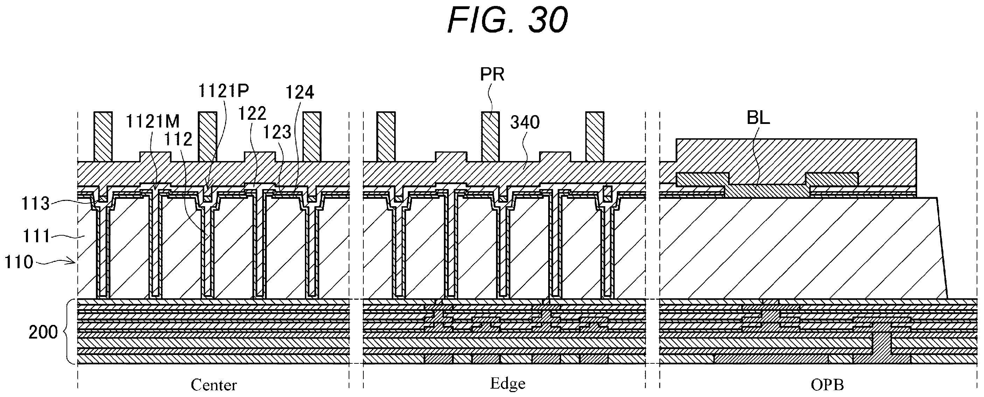

Subsequently, as illustrated in Fig. 30, a mask layer PR patterned to define each of the pixels 12 is formed on the temporary wall portion 340. For example, in the region Center on the central side of the pixel unit 13A, the mask layer PR is patterned and provided immediately above the pixel isolation unit 112 that defines the photoelectric conversion unit 111 of each of the pixels 12. On the other hand, in the region Edge on the peripheral edge side of the pixel unit 13A, the mask layer PR is patterned and provided at a position shifted by a pupil correction from the top of the pixel isolation unit 112 that defines the photoelectric conversion unit 111 of each of the pixels 12.

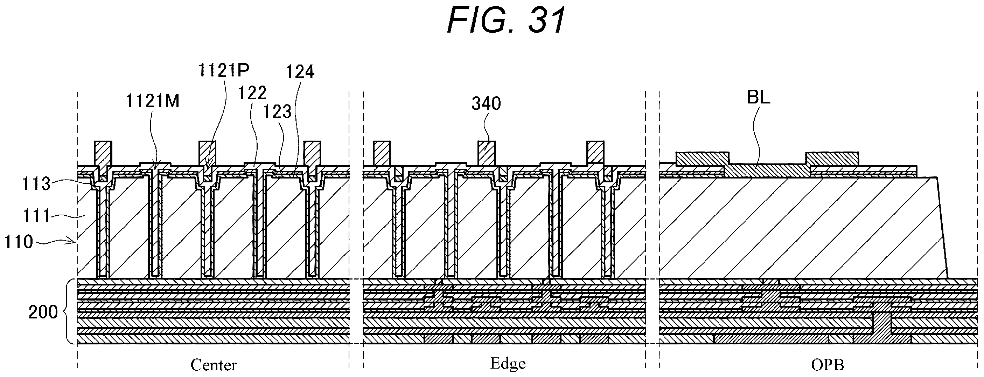

Thereafter, as illustrated in Fig. 31, after the temporary wall portion 340 is etched using the mask layer PR, the color filter 130 is provided in a region between the temporary wall portions 340 so as to correspond to the pixels 12. Moreover, after the inter-filter isolation unit 140 is formed between the color filters 130, the on-chip lens 151 on the color filter 130 is formed.

Through the above steps, the pixel unit 13A is manufactured.

### (Method of Manufacturing Pixel Unit 13B)

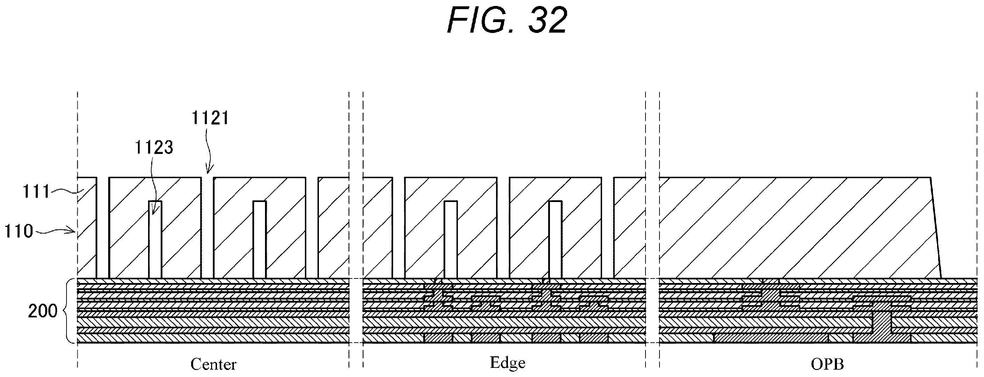

A method of manufacturing the pixel unit 13B according to the modification of the first embodiment will be described with reference to Figs. 32 to 42. Figs. 32 to 42 are longitudinal cross-sectional views illustrating a step of manufacturing the pixel unit 13B according to the modification of the first embodiment.

Note that, in Figs. 32 to 42, "Center" indicates a region on the central side of the pixel unit 13B, and "Edge" indicates a region on the peripheral edge side of the pixel unit 13B. In addition, "OPB" indicates an optically black region provided in the pixel unit 13B. The optically black region is a region for detecting dark noise by the light-shielded photoelectric conversion unit 111.

First, as illustrated in Fig. 32, the circuit layer 200 including a pixel transistor, wiring, and the like and a semiconductor substrate 110 are bonded together, and the bonded semiconductor substrate 110 is etched to form an opening 1121. For example, the opening 1121 may be provided so as to penetrate the semiconductor substrate 110 formed by silicon. The opening 1121 is a recess in which the pixel isolation unit 112 is formed in a subsequent process.

In the pixel unit 13B, an opening 1123 is further formed in the semiconductor substrate 110 from the surface side bonded to the circuit layer 200. The opening 1123 is a recess in which a part of the sub-pixel isolation unit 114 is formed in a subsequent process, and is formed in the semiconductor substrate 110 before being bonded to the circuit layer 200. Thereafter, the semiconductor substrate 110 is bonded to the circuit layer 200 after the opening 1123 is formed.

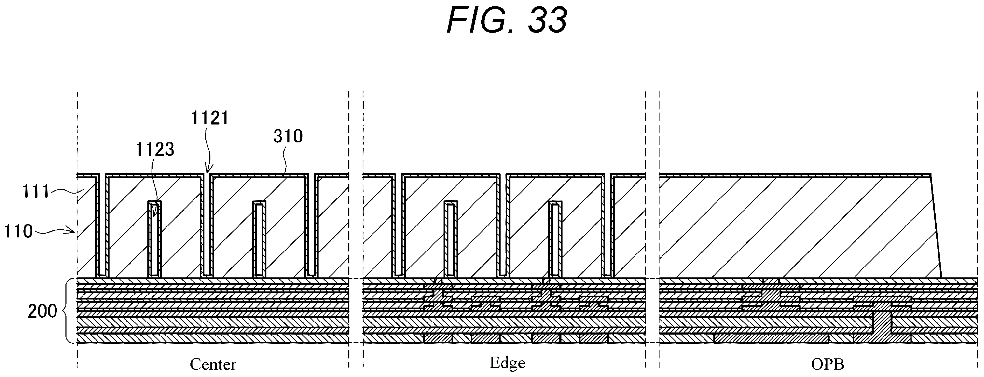

Next, as illustrated in Fig. 33, a protective film 310 is formed on the exposed surface of the semiconductor substrate 110 by ALD. The protective film 310 is formed by, for example, silicon oxide (SiO₂) or the like, and is formed with a uniform thickness on the exposed surface of the semiconductor substrate 110 including the opening 1121 and a bottom surface and an inner side surface of the opening 1123. In the opening 1123, the side surface communicates with the opening 1121, and a raw material gas flows through the opening 1121 to form the protective film 310.

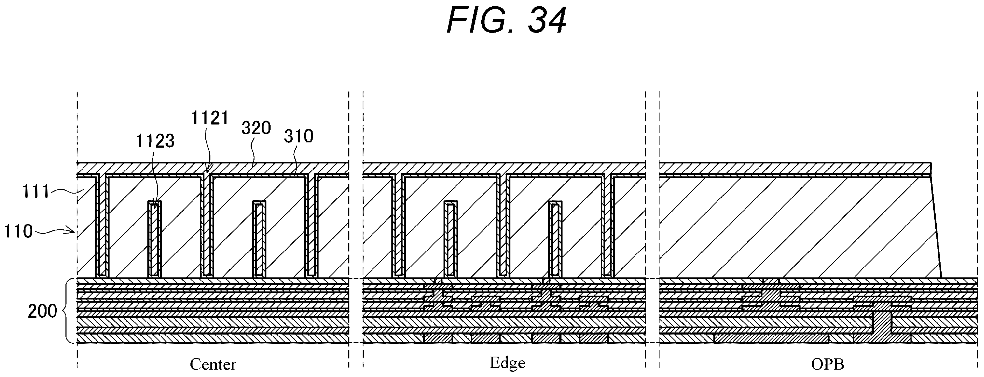

Subsequently, as illustrated in Fig. 34, a resist layer 320 is formed so as to fill the opening 1121 and the opening 1123 and cover the surface of the semiconductor substrate 110. The resist layer 320 may be, for example, an i-line resist. The opening 1123 is embedded in the resist layer 320 by the resist flowing through the opening 1121 communicating with the side surface.

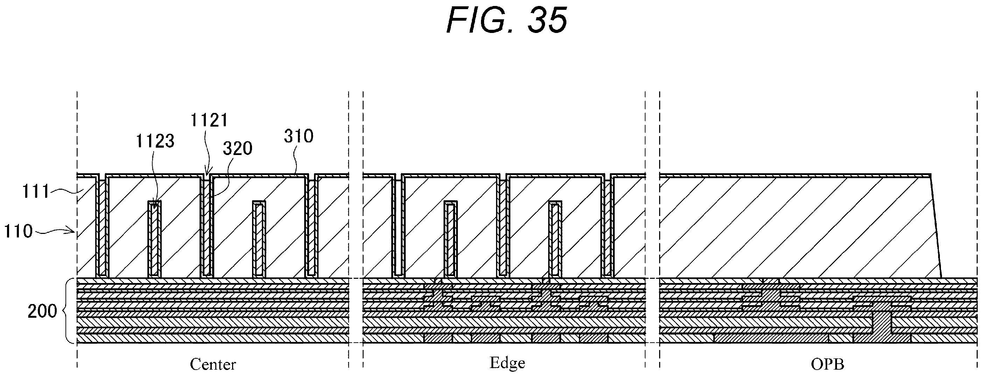

Next, as illustrated in Fig. 35, by exposing the entire surface of the resist layer 320, the resist layer 320 is retracted until the protective film 310 provided on the surface of the semiconductor substrate 110 is exposed. At this time, in the opening 1121 in which the pixel isolation unit 112 is formed, the exposed resist layer 320 is exposed so as to retreat to the inside of the opening 1121.

Note that since the opening 1123 is embedded in the semiconductor substrate 110 with the resist layer 320, the opening is not affected by the process until the resist layer 320 is removed. According to this, in the pixel unit 13B, the process for widening the opening width of the opening 1121 can be performed in a self-aligned manner.

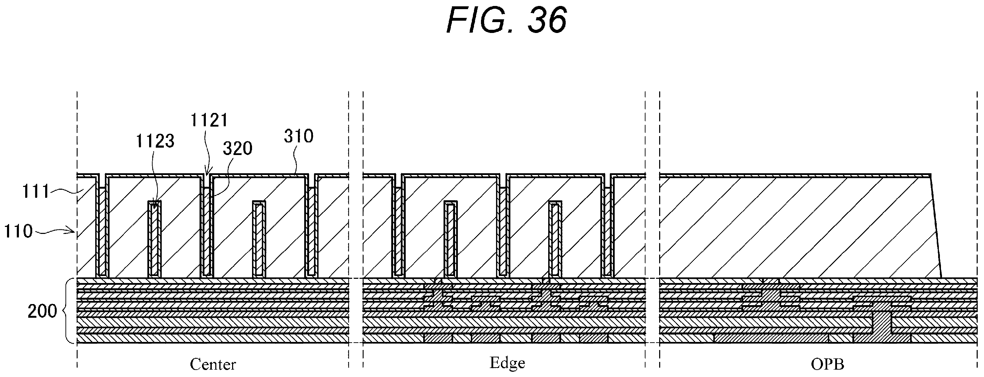

Subsequently, as illustrated in Fig. 36, etching (etch-back) is performed on the entire surface of the semiconductor substrate 110. Thus, a retraction amount of the resist layer 320 in the opening 1121 in which the pixel isolation unit 112 is formed is controlled to a target depth.

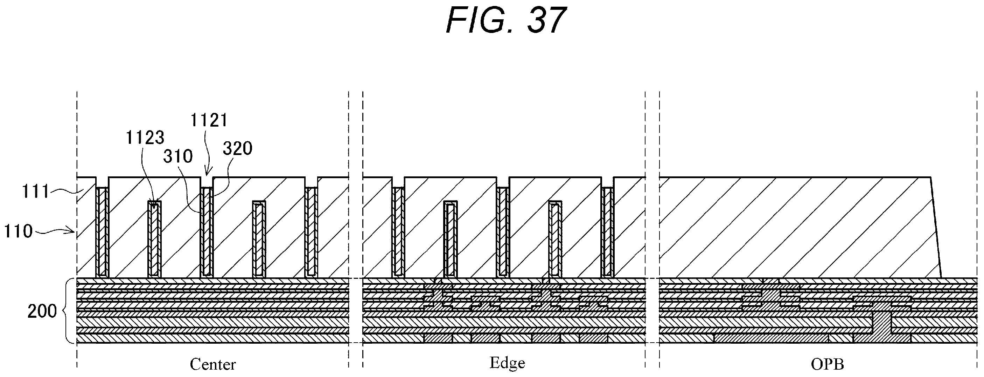

Next, as illustrated in Fig. 37, the protective film 310 not masked by the resist layer 320 is removed by etching with diluted hydrofluoric acid (DHF).

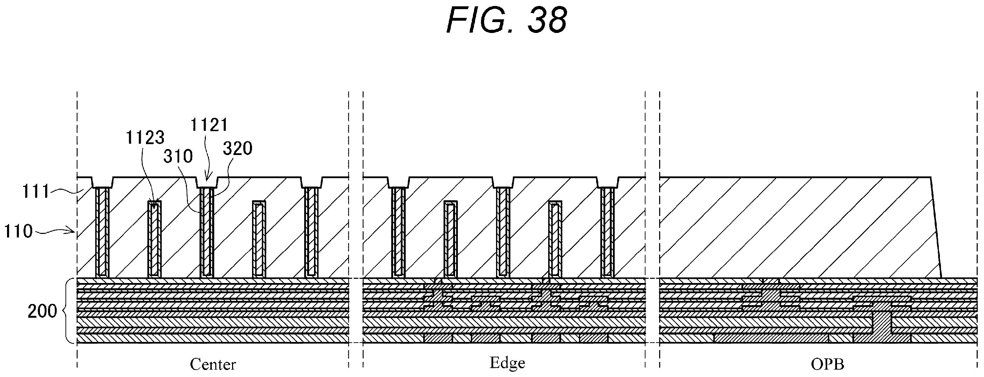

Subsequently, as illustrated in Fig. 38, a region of the semiconductor substrate 110 that is not masked by the protective film 310 and the resist layer 320 is isotropically etched by chemical dry etching (CDE). Thus, the opening width of the upper portion of the opening 1121 is widened.

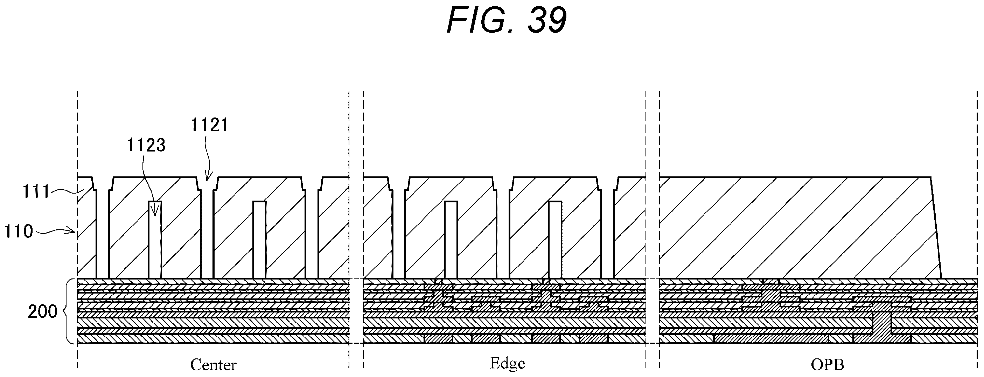

Thereafter, as illustrated in Fig. 39, the protective film 310 and the resist layer 320 are removed. Thus, the protective film 310 and the resist layer 320 in which the opening 1121 and the opening 1123 are embedded are removed, so that the inside of the opening 1121 and the opening 1123 is exposed.

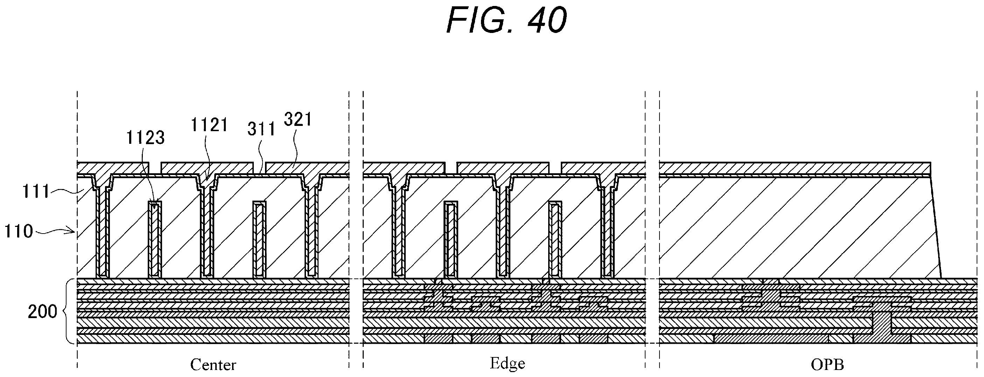

Next, as illustrated in Fig. 40, a protective film 311 and a resist layer 321 are formed again on the exposed surface of the semiconductor substrate 110 except for the surface of the semiconductor substrate 110 opposite to the opening 1123.

Specifically, the protective film 311 is formed with a uniform thickness on the exposed surface of the semiconductor substrate 110 including the opening 1121 and a bottom surface and an inner side surface of the opening 1123. The resist layer 321 is formed so as to fill the opening 1123 and the opening 1121 and cover the surface of the semiconductor substrate 110 except for the surface of the semiconductor substrate 110 opposite to the opening 1123. In the opening 1123, the protective film 311 and the resist layer 321 are formed by flowing the material through the opening 1121 communicating with the side surface.

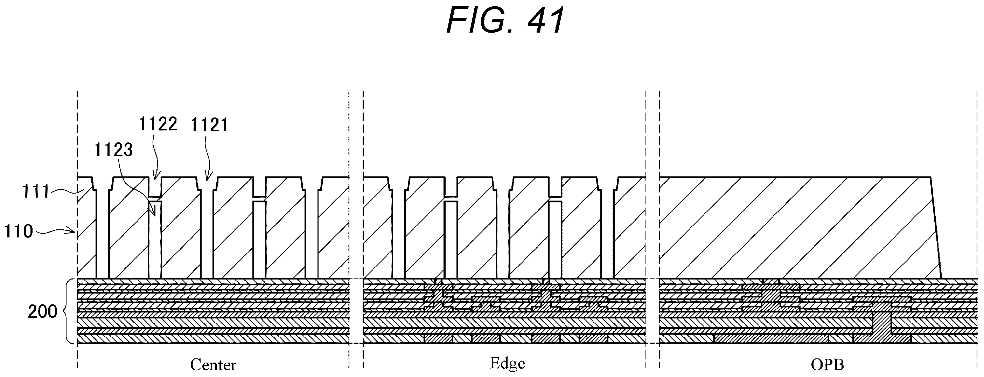

Subsequently, as illustrated in Fig. 41, by etching the opening of the resist layer 321 on the front surface side of the semiconductor substrate 110, the opening 1122 is formed on the surface opposite to the surface on which the opening 1123 is formed. Thereafter, the protective film 311 and the resist layer 321 are removed. The opening 1122 is a recess in which the first sub-pixel isolation unit 114A is formed in a subsequent process corresponding to the opening 1123 in which the second sub-pixel isolation unit 114B is formed. Note that the opening 1122 and the opening 1123 may communicate with each other.

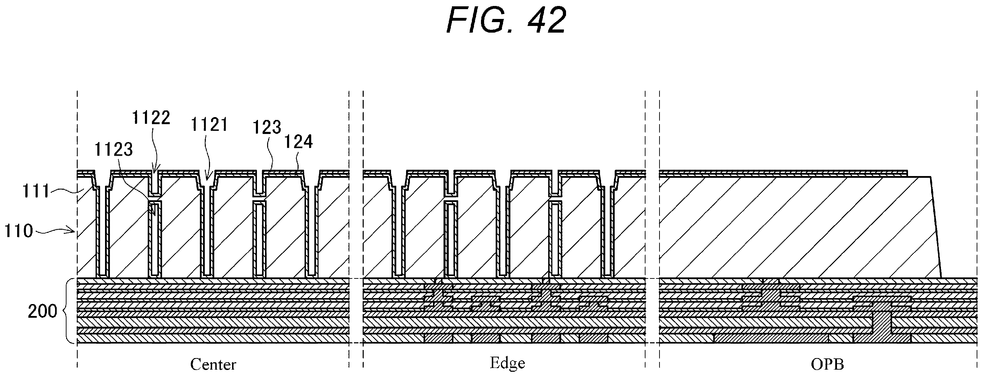

Next, as illustrated in Fig. 42, the fixed charge layer 124 and the reflection control layer 123 are sequentially formed by ALD along the shape of the semiconductor substrate 110. For example, the fixed charge layer 124 may be formed with a uniform thickness on the exposed surface of the semiconductor substrate 110 including the bottom surface and the inner side surface of the opening 1121, the opening 1122, and the opening 1123. Furthermore, the reflection control layer 123 may be formed only on the fixed charge layer 124 provided on the surface of the semiconductor substrate 110.

As described above, with the pixel unit 13 according to the first embodiment, the isolation ratio between the sub-pixels can be improved by isolating the pixels 12 by the pixel isolation unit 112 and isolating the sub-pixels by the sub-pixel isolation unit 114. Furthermore, the pixel unit 13 can achieve both improvement in quantum efficiency and suppression of crosstalk between the pixels 12 by providing the light shielding unit 113 on the pixel isolation unit 112.

### <2. Second Embodiment>

### (2.1. Configuration Example)

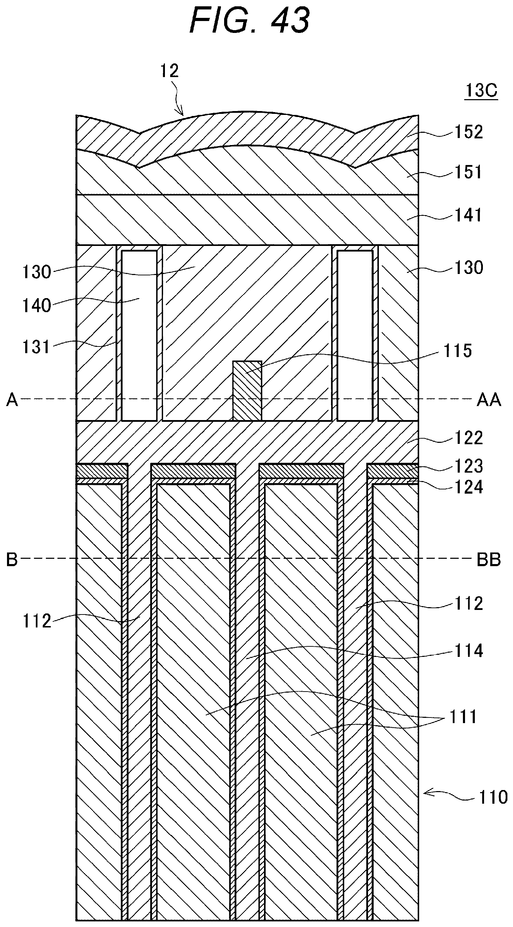

A configuration example of the pixel unit 13 according to the second embodiment of the present disclosure will be described with reference to Fig. 43. Fig. 43 is a longitudinal cross-sectional view illustrating a cross-sectional configuration of a pixel unit 13C according to a configuration example of the second embodiment.

As illustrated in Fig. 43, the pixel unit 13C includes a semiconductor substrate 110 in which photoelectric conversion units 111 are provided, a dielectric layer 122, a reflection control layer 123, a fixed charge layer 124, a color filter 130, an inter-filter isolation unit 140, a low refractive index region 115, an insulating layer 141, an on-chip lens 151, and an antireflection film 152. The pixels 12 included in the pixel unit 13C are pixels each having a plurality of sub-pixels in which light receiving regions are divided with respect to one color filter 130 and one on-chip lens 151. Such a pixel 12 is used, for example, as a phase difference pixel that detects the distance to the subject on the basis of a pixel signal obtained in each of the sub-pixels.

The semiconductor substrate 110 is, for example, a substrate having a thickness of 1 µm to 6 µm and constituted by silicon (Si). In the semiconductor substrate 110, a photoelectric conversion unit 111 that generates a signal charge corresponding to the amount of received incident light is provided for each pixel 12. The photoelectric conversion unit 111 is a photodiode, and is constituted by PN junction between a semiconductor region of a first conductivity type (for example, p-type) and a semiconductor region of a second conductivity type (for example, n-type). For example, the photoelectric conversion unit 111 may be constituted by providing a semiconductor region of the second conductivity type (for example, n-type) inside a well region of the first conductivity type (for example, p-type) for each pixel 12.

The photoelectric conversion units 111 provided for the respective pixels 12 are physically and electrically separated from each other in a pixel isolation unit 112 formed by an insulating material. The pixel isolation unit 112 may include, for example, an insulating material such as silicon oxide (SiOₓ), silicon nitride (SiN), or silicon oxynitride (SiON) extending in a thickness direction of the semiconductor substrate 110 to separate the photoelectric conversion unit 111 in each pixel 12.

Furthermore, the photoelectric conversion unit 111 separated by the pixel isolation unit 112 for each pixel 12 is further physically and electrically separated by a sub-pixel isolation unit 114 for each sub-pixel. The sub-pixel isolation unit 114 is provided by extending an insulating material such as silicon oxide (SiOₓ), silicon nitride (SiN), or silicon oxynitride (SiON) in the thickness direction of the semiconductor substrate 110, for example.

The fixed charge layer 124 is formed by a material having a negative fixed charge, and is provided at an interface between the semiconductor substrate 110 and another layer. Specifically, the fixed charge layer 124 may be constituted by a high dielectric material having a negative fixed charge such as hafnium oxide (HfO₂), zirconium oxide (ZrO₂), aluminum oxide (Al₂O₃), tantalum oxide (Ta₂O₅), titanium oxide (TiO₂), magnesium oxide (MgO), yttrium oxide (Y₂O₃), or an oxide of a lanthanoid. The fixed charge layer 124 can suppress generation of a dark current at the interface between the semiconductor substrate 110 and another layer by forming a region in which positive charges are accumulated at the interface with the semiconductor substrate 110 by negative fixed charges.

The reflection control layer 123 is provided using an insulating material having a refractive index smaller than the refractive index of the high dielectric material forming the fixed charge layer 124, and is provided on the fixed charge layer 124 provided on the surface of the semiconductor substrate 110. Since the reflection control layer 123 can suppress reflection of light incident on the reflection control layer 123 from the on-chip lens 151, it is possible to improve the incident efficiency of light on the photoelectric conversion unit 111. The reflection control layer 123 may be formed by, for example, tantalum oxide (Ta₂O₅).

The dielectric layer 122 is formed by an insulating material, and is provided on the reflection control layer 123 continuously over the plurality of pixels 12. For example, the dielectric layer 122 may be formed by an insulating material such as silicon oxide (SiOₓ), silicon nitride (SiN), or silicon oxynitride (SiON). Furthermore, the dielectric layer 122 may be formed by the same insulating material (that is, the dielectric material) as that of the pixel isolation unit 112 using the same ALD process as that of the pixel isolation unit 112. According to this, in the pixel unit 13C, since the dielectric layer 122 and the pixel isolation unit 112 can be formed in the same process, the manufacturing process can be simplified.

The color filter 130 is provided for each pixel 12 on the dielectric layer 122, and selectively transmits light (for example, red light (R), green light (G), and blue light (B)) in a wavelength band corresponding to each pixel 12. The color filter 130 may be provided in a predetermined RGB array such as a Bayer array, for example.

The inter-filter isolation unit 140 includes a low refractive index material having a refractive index lower than the refractive index of the color filter 130, and is provided between the color filters 130 provided for the respective pixels 12. The low refractive index material included in the inter-filter isolation unit 140 may be air having a refractive index of approximately 1. Furthermore, the low refractive index material contained in the inter-filter isolation unit 140 may be, for example, an inorganic material such as silicon oxide (SiO₂), silicon nitride (SiN), or silicon oxynitride (SiON), may be a resin material such as a styrene resin, an acrylic resin, a styrene-acrylic copolymer resin, or a siloxane resin, or may be a so-called low-k material such as SiOF, SiOC, or porous silica.

In a case where the low refractive index material included in the inter-filter isolation unit 140 is air, the gap of the inter-filter isolation unit 140 may be defined by surrounding the side surface and the upper surface with a contour portion 131 formed by an insulating material. Such an inter-filter isolation unit 140 can be formed, for example, by the following method. Specifically, first, a temporary wall is formed in a region where a gap is formed between the pixels 12, and then the contour portion 131 is formed on the side surface and the upper surface of the temporary wall so as to cover the temporary wall. Next, the color filter 130 is formed in the region of the pixel 12 between the temporary walls covered with the contour portion 131. Thereafter, an opening is provided in the contour portion 131 on the upper surface, and the temporary wall inside the contour portion 131 is removed by etching through the opening, whereby a gap can be formed inside the contour portion 131. Note that the opening formed in the contour portion 131 on the upper surface to remove the temporary wall is closed by the insulating layer 141 provided between the color filter 130 and the on-chip lens 151. Thus, the inter-filter isolation unit 140 in which the outer shape of the gap is defined by the contour portion 131 can be formed between the color filters 130.

The refractive index of the low refractive index material included in the inter-filter isolation unit 140 is lower than the refractive index of the color filter 130. Thus, the color filter 130 and the inter-filter isolation units 140 on both sides of the color filter 130 can function as a waveguide in which a high refractive index material is sandwiched between low refractive index materials. Therefore, the inter-filter isolation unit 140 can suppress crosstalk to the adjacent pixel 12 by reflecting light traveling to the adjacent pixel 12 at the interface with the color filter 130.

The low refractive index region 115 is a region having a refractive index lower than the refractive index of the color filter 130, and is provided inside the color filter 130 on the semiconductor substrate 110 side so as to correspond to the sub-pixel isolation unit 114. The low refractive index region 115 may be formed by, for example, an inorganic material such as silicon oxide (SiO₂), silicon nitride (SiN), or silicon oxynitride (SiON) having a refractive index lower than the refractive index of the color filter 130, or may be formed by a resin material such as a styrene resin, an acrylic resin, a styrene-acrylic copolymer resin, or a siloxane resin. Furthermore, the low refractive index region 115 may be constituted by a so-called low-k material such as SiOF, SiOC, or porous silica.

The low refractive index region 115 can form a waveguide in which the high refractive index material (color filter 130) is sandwiched between the low refractive index material (the low refractive index region 115 and the inter-filter isolation unit 140) between he low refractive index region 115 and the inter-filter isolation unit 140 provided between the color filters 130. According to this, the low refractive index region 115 can more efficiently guide the incident light to each of the sub-pixels separated by the sub-pixel isolation unit 114. Therefore, the low refractive index region 115 can further increase the isolation ratio between the sub-pixels by further suppressing crosstalk between the sub-pixels.

The low refractive index region 115 may be provided on the dielectric layer 122 at a relatively lower height than the inter-filter isolation unit 140 and the color filter 130. For example, the low refractive index region 115 may be provided at a height of about half the height of the inter-filter isolation unit 140 and the color filter 130. By providing the low refractive index region 115 so that the upper surface exists in the vicinity of the light collection center by the on-chip lens 151, the incident light collected by the on-chip lens 151 can be more efficiently guided to each of the sub-pixels.

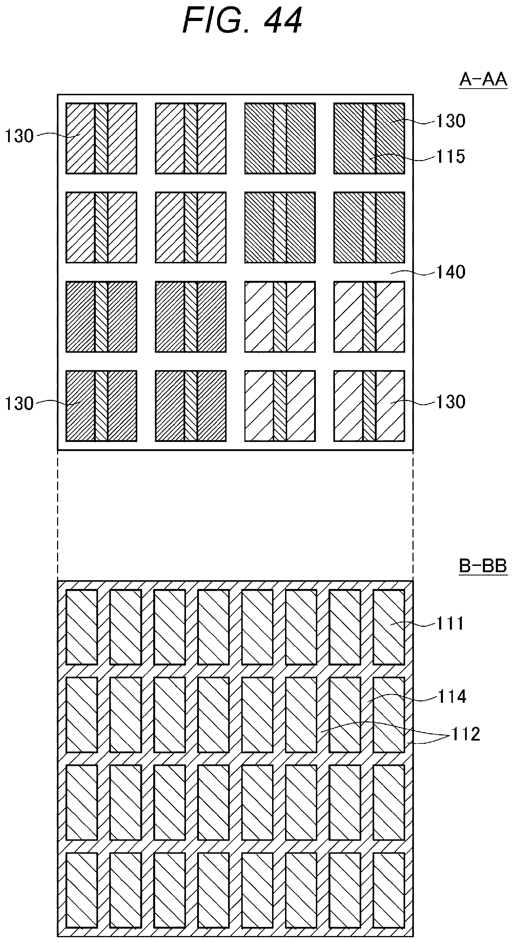

With reference to Fig. 44, a positional relationship on a plane between the low refractive index region 115 and the inter-filter isolation unit 140, and the pixel isolation unit 112 and the sub-pixel isolation unit 114 will be described. Fig. 44 is a transverse cross-sectional view illustrating a planar configuration in an A-AA cross section and a B-BB cross section of Fig. 43.

As illustrated in Fig. 44, in the B-BB cross section, the pixel isolation unit 112 may separate the photoelectric conversion units 111 from each other in a substantially square shape corresponding to the respective pixels 12 planarly arranged in a matrix. The sub-pixel isolation unit 114 may further separate each of the pixels 12 separated by the pixel isolation unit 112 into two rectangular sub-pixels by extending in one direction from the pixel isolation unit 112 at one end to the pixel isolation unit 112 at the other end. On the other hand, in the A-AA cut surface, the inter-filter isolation unit 140 may be provided on the pixel isolation unit 112 in the same planar arrangement as the pixel isolation unit 112 to separate the pixels 12 arranged in a matrix from each other. The low refractive index region 115 may be provided on the sub-pixel isolation unit 114 in the same planar arrangement as the sub-pixel isolation unit 114 to separate each of the pixels 12 into two rectangular sub-pixels.

The insulating layer 141 is provided on the contour portion 131 on the upper surface of the inter-filter isolation unit 140 and the color filter 130 continuously over the plurality of pixels 12. The insulating layer 141 may be formed by an insulating material such as silicon oxide (SiOₓ), silicon nitride (SiN), or silicon oxynitride (SiON). The insulating layer 141 may be formed on the contour portion 131 and the color filter 130 with a high coverage.

The insulating layer 141 may be formed by an insulating material having a refractive index substantially the same as the refractive index of the on-chip lens 151 described later or smaller than the refractive index of the on-chip lens 151. The above "substantially the same" may mean that, for example, a difference between the refractive index of the insulating layer 141 and the refractive index of the on-chip lens 151 is within 0.1. According to this, the insulating layer 141 can suppress reflection of incident light at the interface between the on-chip lens 151 and the insulating layer 141, the amount of light incident on the photoelectric conversion unit 111 can be further increased. For example, in a case where the on-chip lens 151 is formed by a general optical organic resin (the refractive index is approximately 1.5 to 1.6), the insulating layer 141 may be formed by silicon oxynitride (SiON) having a refractive index of 1.58.

The on-chip lens 151 is a convex lens that collects incident light, and is provided for each pixel 12 on the insulating layer 141. The on-chip lens 151 may be constituted by, for example, a resin material such as a styrene resin, an acrylic resin, a styrene-acrylic copolymer resin, or a siloxane resin. The on-chip lens 151 collects the light incident on the pixel 12 on the central portion of the pixel 12, so that the light incident on the pixel 12 can be more efficiently incident on the photoelectric conversion unit 111.

Furthermore, the antireflection film 152 may be formed on the surface layer of the on-chip lens 151. The antireflection film 152 is configured as, for example, a dielectric multilayer film. The antireflection film 152 can suppress reflection of light incident on the on-chip lens 151.

### (2.2. Modification)

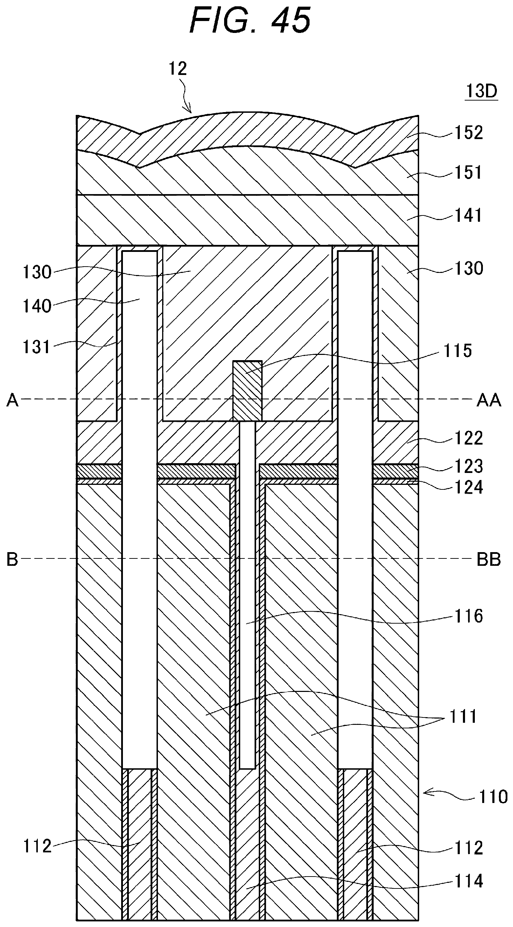

A modification of the pixel unit 13 according to the present embodiment will be described with reference to Fig. 45. Fig. 45 is a longitudinal cross-sectional view illustrating a cross-sectional configuration of a pixel unit 13D according to a modification of the second embodiment.

As illustrated in Fig. 45, the pixel unit 13D includes a semiconductor substrate 110 in which photoelectric conversion units 111 are provided, a dielectric layer 122, a reflection control layer 123, a fixed charge layer 124, a color filter 130, an inter-filter isolation unit 140, a low refractive index region 115, a gap 116, an insulating layer 141, an on-chip lens 151, and an antireflection film 152. The pixels 12 included in the pixel unit 13D are pixels each having a plurality of sub-pixels in which light receiving regions are divided with respect to one color filter 130 and one on-chip lens 151.

The pixel unit 13D according to the modification is different from the pixel unit 13C illustrated in Fig. 43 in that the inter-filter isolation unit 140 extends to the photoelectric conversion unit 111, and the gap 116 for separating the photoelectric conversion units 111 is further provided corresponding to the low refractive index region 115.

Specifically, the inter-filter isolation unit 140 may be provided so that a low refractive index material (that is, a gap) extends to the inside of the semiconductor substrate 110 through the dielectric layer 122 and the reflection control layer 123 from between the color filters 130. Thus, the inter-filter isolation unit 140 is provided to extend from between the color filters 130 so that the low refractive index material (that is, the gap) replaces a part of the pixel isolation unit 112 and the fixed charge layer 124 provided in the semiconductor substrate 110. Therefore, the inter-filter isolation unit 140 can separate the photoelectric conversion unit 111 provided in the semiconductor substrate 110 from each pixel 12 together with the pixel isolation unit 112.

Such an inter-filter isolation unit 140 can be formed, for example, by the following method. Specifically, first, the fixed charge layer 124, the reflection control layer 123, and the dielectric layer 122 are sequentially laminated on the semiconductor substrate 110 provided with the pixel isolation unit 112, and then the region provided with the pixel isolation unit 112 is etched together with the pixel isolation unit 112. Subsequently, a temporary wall in which the etched opening is embedded is formed in a region where the inter-filter isolation unit 140 between the pixels 12 is formed, and then the contour portion 131 is formed on a side surface and an upper surface of the temporary wall so as to cover the temporary wall. Next, the pixel 12 is formed by forming the color filter 130 in a region between the temporary walls covered with the contour portion 131. Thereafter, an opening is provided in the contour portion 131 on the upper surface, and the temporary wall inside the contour portion 131 is removed to the inside of the semiconductor substrate 110 through the opening by etching, whereby the inter-filter isolation unit 140 in which the gap extends to the inside of the semiconductor substrate 110 can be formed.

The gap 116 may be provided to extend from below the low refractive index region 115 through the dielectric layer 122 and the reflection control layer 123 to the inside of the semiconductor substrate 110. Thus, the gap 116 is provided to extend from below the low refractive index region 115 so as to replace a part of the sub-pixel isolation unit 114 provided in the semiconductor substrate 110. Therefore, the gap 116 can separate the photoelectric conversion unit 111 provided in the semiconductor substrate 110 from each sub-pixel together with the sub-pixel isolation unit 114.

Such gaps 116 can be formed, for example, by the following method. Specifically, first, the fixed charge layer 124, the reflection control layer 123, and the dielectric layer 122 are sequentially laminated on the semiconductor substrate 110 provided with the sub-pixel isolation unit 114, and then a region provided with the sub-pixel isolation unit 114 is etched. Subsequently, the etched opening is closed by the low refractive index region 115. Thus, the gap 116 extending to the inside of the semiconductor substrate 110 can be formed under the low refractive index region 115.

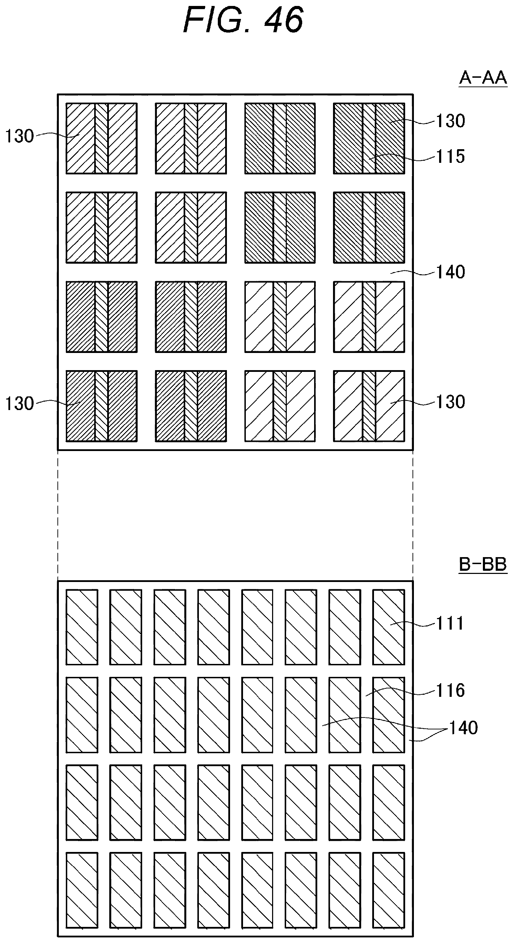

With reference to Fig. 46, a positional relationship on a plane of the low refractive index region 115, the inter-filter isolation unit 140, and the gap 116 will be described. Fig. 46 is a transverse cross-sectional view illustrating a planar configuration in an A-AA cross section and a B-BB cross section of Fig. 45.

As illustrated in Fig. 46, in the B-BB cross section, the inter-filter isolation unit 140 may separate the photoelectric conversion units 111 from each other in a substantially square shape corresponding to the respective pixels 12 planarly arranged in a matrix. The gap 116 may extend in one direction from the inter-filter isolation unit 140 at one end to the inter-filter isolation unit 140 at the other end to further separate each of the pixels 12 separated by the inter-filter isolation unit 140 into two rectangular sub-pixels. On the other hand, the inter-filter isolation unit 140 may separate the pixels 12 arranged in a matrix from each other on the A-AA cut surface, similarly to the B-BB cut surface. The low refractive index region 115 may be provided on the gap 116 in the same planar arrangement as the gap 116 to separate each of the pixels 12 into two rectangular sub-pixels.

### (2.3. Planar Configuration of Low Refractive Index Region)

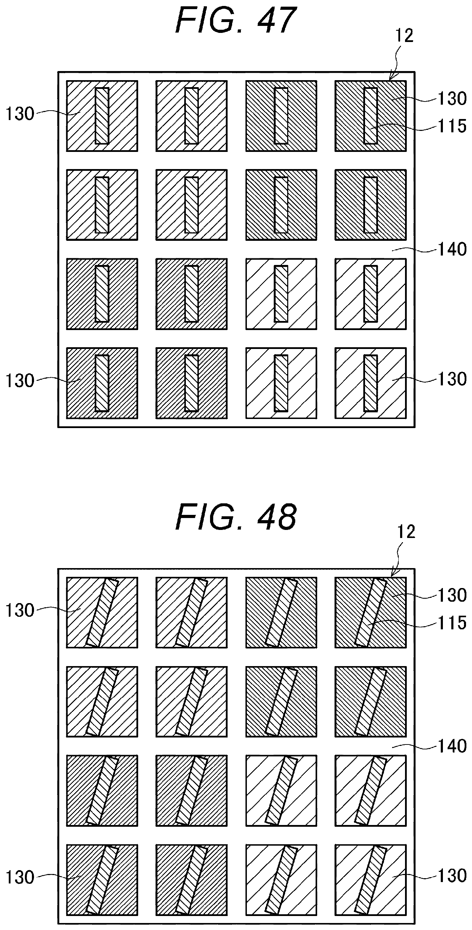

The planar arrangement of the low refractive index region 115 will be described with reference to Figs. 47 to 52. The low refractive index region 115 may be arranged in any planar layout as long as it is provided on the sub-pixel isolation unit 114 so as to correspond to the sub-pixel isolation unit 114.

Figs. 47 to 49 are plan views illustrating an example of a planar arrangement of the low refractive index region 115 in the pixel 12 divided into two left and right sub-pixels. Even in the planar arrangement illustrated in Figs. 47 to 49, the low refractive index region 115 can form a waveguide between the low refractive index region and the inter-filter isolation unit 140, so that the collected incident light can be separated into each of the sub-pixels.

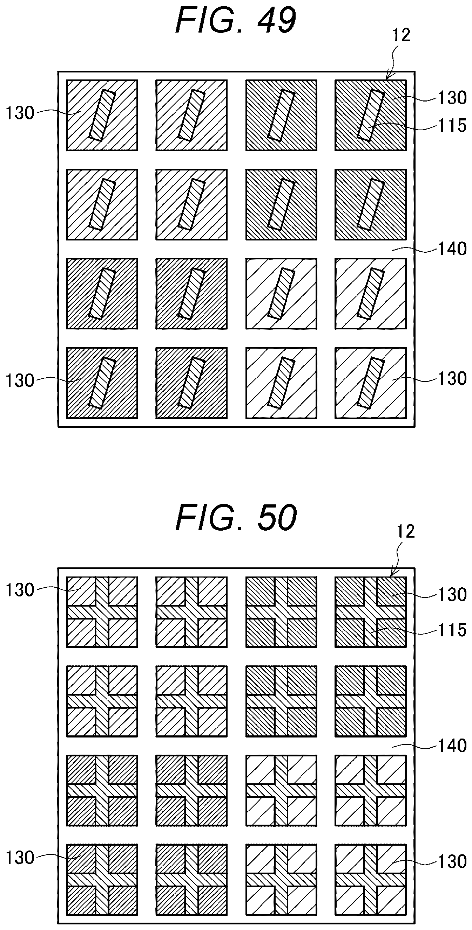

As illustrated in Fig. 47, the low refractive index region 115 may be provided in an island shape in the pixel 12 while extending in one direction. That is, the low refractive index region 115 need not be in contact with the inter-filter isolation unit 140 at one end or both ends and need not completely divide the sub-pixel. As illustrated in Fig. 48, the low refractive index region 115 may be provided to be inclined with respect to the sub-pixel isolation unit 114 that vertically divides the pixel 12. As illustrated in Fig. 49, the low refractive index region 115 may be inclined with respect to the sub-pixel isolation unit 114 that vertically divides the pixel 12, and may be provided in an island shape in the pixel 12.

Figs. 50 to 52 are plan views illustrating an example of a planar arrangement of the low refractive index region 115 in the pixel 12 divided into four sub-pixels in a cross shape. Even in the planar arrangement illustrated in Figs. 50 to 52, the low refractive index region 115 can form a waveguide between the low refractive index region and the inter-filter isolation unit 140, so that the collected incident light can be separated into each of the sub-pixels.

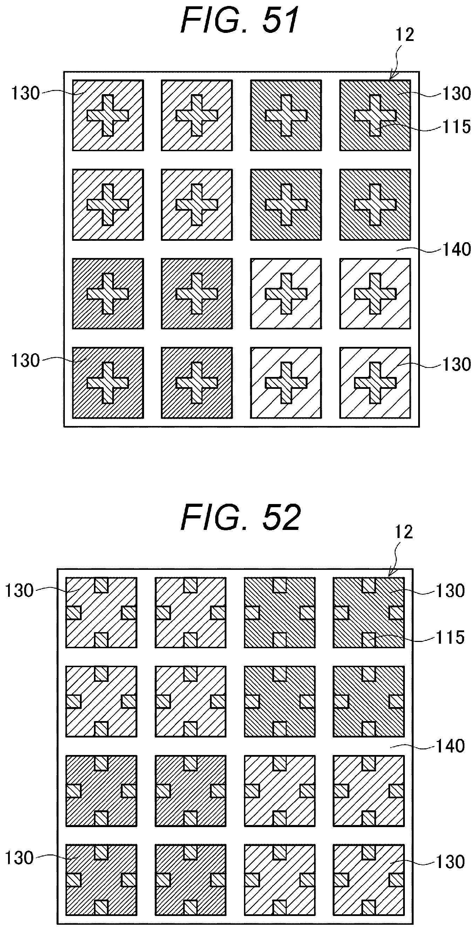

As illustrated in Fig. 50, the low refractive index region 115 may extend crosswise from the inter-filter isolation unit 140 at one end to the inter-filter isolation unit 140 at the other end to divide the pixel 12 into four sub-pixels. As illustrated in Fig. 51, the low refractive index region 115 may extend crosswise and be provided in an island shape in the pixel 12. That is, the low refractive index region 115 need not be in contact with the inter-filter isolation unit 140 at one end or both ends and need not completely divide the sub-pixel. As illustrated in Fig. 52, the low refractive index region 115 may be divided into a plurality of portions extending in a cross shape and separated from each other at the central portion of the pixel 12. For example, as illustrated in Fig. 52, the refractive index region 115 need not be provided in the central portion of the pixel 12.

As described above, with the pixel unit 13 according to the second embodiment, by separating the pixels 12 by the pixel isolation unit 112 and separating the sub-pixels by the sub-pixel isolation unit 114, the isolation ratio between the sub-pixels can be improved. Furthermore, the pixel unit 13 can further improve the quantum efficiency and the isolation ratio between the sub-pixels by providing the low refractive index region 115 on the sub-pixel isolation unit 114.

### <3. Electronic Device>

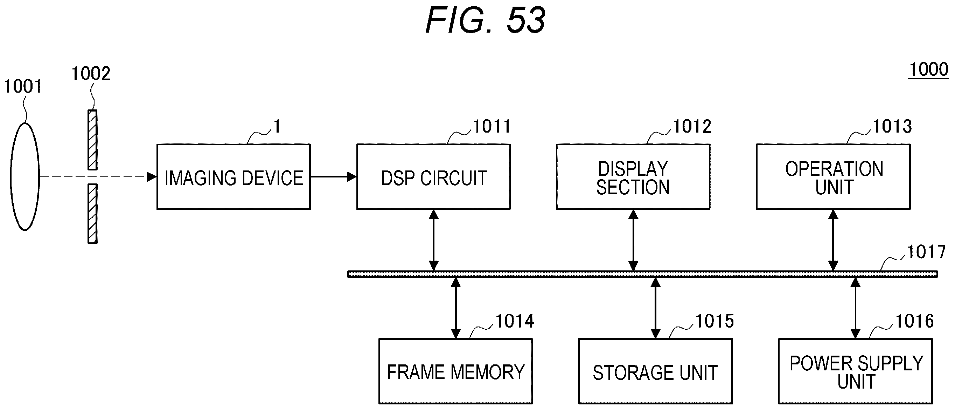

Next, an electronic device including the imaging device 1 according to the above embodiment will be described with reference to Fig. 53. Fig. 53 is a block diagram illustrating a configuration example of an electronic device 1000 including the imaging device 1 according to the embodiment. For example, the electronic device 1000 may be a general electronic device using an imaging device as an image capturing unit (photoelectric conversion unit), such as an imaging device such as a digital camera or a video camera, a mobile terminal device having an imaging function, or a copying machine using an imaging device as an image reading unit. The imaging device may be mounted on the electronic device 1000 in a chip form, or may be mounted on the electronic device 1000 in a module form in which an imaging section and a signal processing section or an optical system are packaged together.

As illustrated in Fig. 53, the electronic device 1000 includes an optical lens 1001, a shutter device 1002, the imaging device 1, a digital signal processor (DSP) circuit 1011, a frame memory 1014, a display section 1012, a storage unit 1015, an operation unit 1013, and a power supply unit 1016. The DSP circuit 1011, the frame memory 1014, the display section 1012, the storage unit 1015, the operation unit 1013, and the power supply unit 1016 are connected to one another via a bus line 1017.

The optical lens 1001 forms an image of incident light from a subject on an imaging surface of the imaging device 1. The shutter device 1002 controls emission or shielding of incident light to the imaging device 1.

The imaging device 1 converts the light amount of the incident light formed as an image on the imaging surface by the optical lens 1001 into an electrical signal in units of pixels and outputs the electrical signal as a pixel signal.

The DSP circuit 1011 is a signal processing circuit that performs general camera signal processing on the pixel signal output from the imaging device 1. The DSP circuit 1011 may perform, for example, a white balance process, a demosaic process, a gamma correction process, or the like.

The frame memory 1014 is a temporary data storage unit. The frame memory 1014 is appropriately used for storing data during signal processing in the DSP circuit 1011.

The display section 1012 includes, for example, a panel type display device such as a liquid crystal panel or an organic electro luminescence (EL) panel. The display section 1012 can display a moving image or a still image captured by the imaging device 1.

The storage unit 1015 includes a storage medium such as a hard disk drive, an optical disk, or a semiconductor memory, and records a moving image or a still image captured by the imaging device 1 in the storage medium.

The operation unit 1013 outputs operation commands for various functions of the electronic device 1000 on the basis of a user's operation.

The power supply unit 1016 is an operation power supply of the DSP circuit 1011, the frame memory 1014, the display section 1012, the storage unit 1015, and the operation unit 1013. The power supply unit 1016 can appropriately supply power to these configurations.

### <4. Application example>

The technology according to the present disclosure (the present technology) can be applied to various products. For example, the technology according to the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

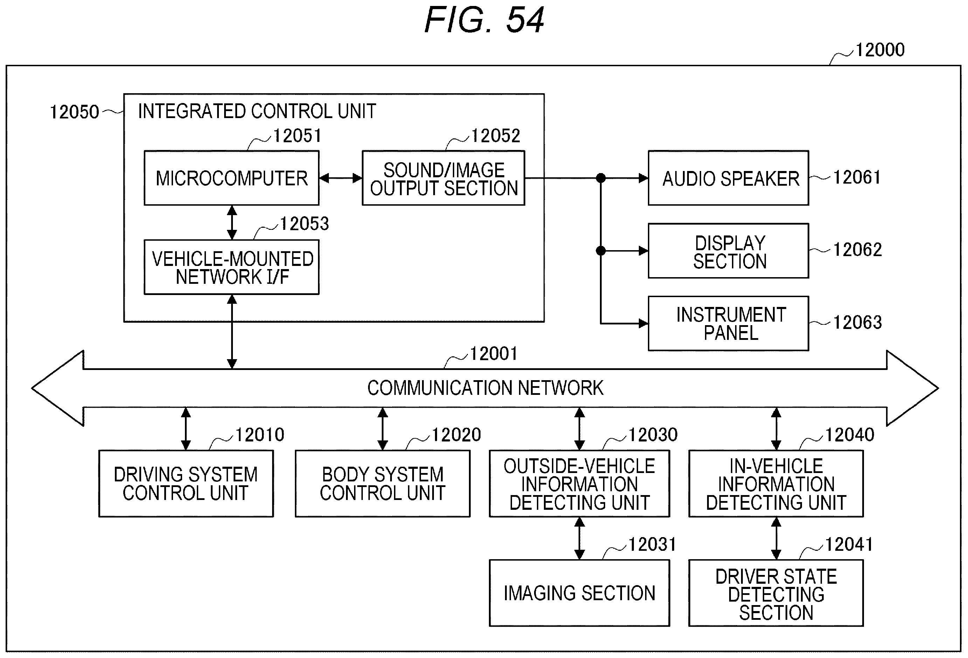

Fig. 54 is a block diagram illustrating a schematic configuration example of a vehicle control system which is an example of a mobile object control system to which the technology according to the present disclosure can be applied.

The vehicle control system 12000 includes a plurality of electronic control units connected to each other via a communication network 12001. In the example illustrated in Fig. 54, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020, on the basis of the information about the outside of the vehicle acquired by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 54, an audio speaker 12061, a display section 12062, and an instrument panel 12063 are illustrated as the output device. The display section 12062 may, for example, include at least one of an on-board display and a head-up display.

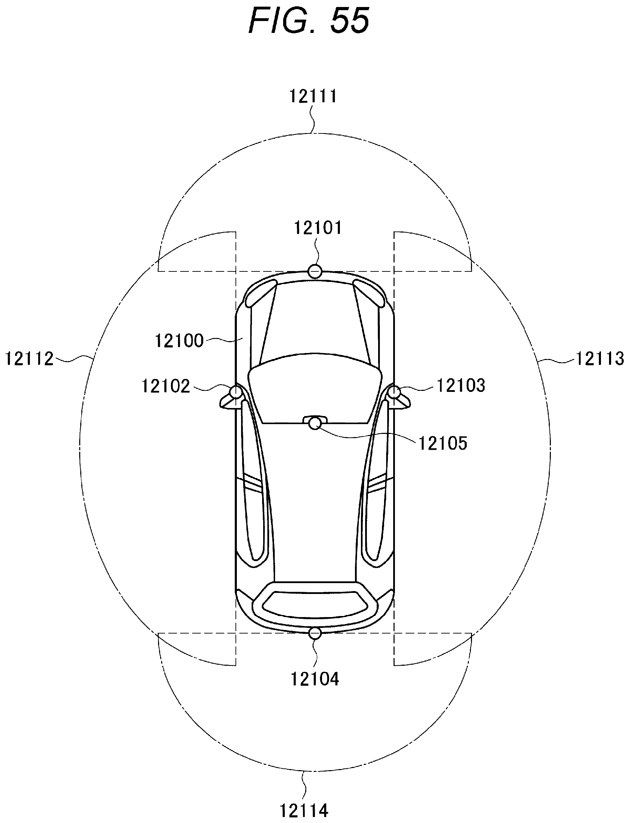

Fig. 55 is a diagram illustrating an example of the installation position of the imaging section 12031.

In Fig. 55, imaging sections 12101, 12102, 12103, 12104, and 12105 are included as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that, Fig. 55 illustrates an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to an embodiment of the present disclosure can be applied to the imaging section 12031 among the configurations described above. By applying the technology according to the present disclosure, the isolation ratio between the pixels or between the sub-pixels can be improved, so that the imaging section 12031 can obtain information with higher accuracy and higher resolution. Therefore, with the technology according to the present disclosure, for example, the imaging section 12031 can recognize an obstacle or a pedestrian in a captured image with higher sensitivity or present a captured image with higher sensitivity to the driver.

Although the preferred embodiment of the present disclosure has been described above in detail with reference to the accompanying drawings, the technical scope of the present disclosure is not limited to such an example. It is obvious that those with ordinary skill in the technical field of the present disclosure can conceive various alterations or corrections within the scope of the technical idea recited in the claims, and it is naturally understood that these alterations or corrections also fall within the technical scope of the present disclosure.

Furthermore, the effects described in the present specification are merely exemplary or illustrative, and not restrictive. That is, the technology according to the present disclosure can exhibit other effects apparent to those skilled in the art from the description of the present specification, in addition to the effects described above or instead of the effects described above.

Note that the following configurations also fall within the technological scope of the present disclosure.
(1) An imaging device including:
   a semiconductor substrate including a photoelectric conversion unit provided for each of pixels arranged two-dimensionally and a pixel isolation unit that isolates the photoelectric conversion units from each other;
   a color filter and an on-chip lens provided for each of the pixels on one surface of the semiconductor substrate;
   an inter-filter isolation unit provided to include a low refractive index material having a refractive index lower than a refractive index of the color filter between the color filters and isolate the color filter for each of the pixels; and
   a sub-pixel isolation unit that isolates the photoelectric conversion units of the pixels including a plurality of sub-pixels for each of the sub-pixels.
(2) The imaging device according to (1), in which
   the pixels each include two of the sub-pixels, and
   the sub-pixel isolation unit separates the photoelectric conversion unit for each of the sub-pixels by extending in one direction.
(3) The imaging device according to (2), in which the sub-pixel isolation unit is divided into two portions separated from each other by being divided at a central portion of the pixel.
(4) The imaging device according to (2) or (3), in which the sub-pixel isolation unit is provided in an island shape in the pixel.
(5) The imaging device according to any one of (2) to (4), in which a light shielding unit is provided on a side of the one surface of the pixel isolation unit.
(6) The imaging device according to any one of (2) to (5), in which the sub-pixel isolation unit is provided continuously between the pixels adjacent to each other across the pixel isolation unit between the pixels adjacent in the one direction.
(7) The imaging device according to any one of (2) to (6), in which the sub-pixel isolation unit is provided to penetrate the semiconductor substrate.
(8) The imaging device according to (7), in which the sub-pixel isolation unit is divided into two portions separated from each other by being divided in a thickness direction of the semiconductor substrate.
(9) The imaging device according to any one of (2) to (8), in which
   the low refractive index material is air, and
   the inter-filter isolation unit includes a gap including the air and an insulating material covering at least a part of an inner wall of the gap.
(10) The imaging device according to (1), in which a low refractive index region having a refractive index lower than a refractive index of the color filter is provided inside the color filter on a side of the semiconductor substrate.
(11) The imaging device according to (10), in which the low refractive index region is provided to extend from a bottom surface of the color filter on the side of the semiconductor substrate to a central portion of the color filter.
(12) The imaging device according to (10) or (11), in which the low refractive index region is provided in a region corresponding to the sub-pixel isolation unit.
(13) The imaging device according to (12), in which the low refractive index region is provided in an island shape in the pixel.
(14) The imaging device according to (12) or (13), in which the low refractive index region is divided into a plurality of portions separated from each other by being divided at a central portion of the pixel.
(15) The imaging device according to any one of (10) to (14), in which
   the low refractive index material is air, and
   a gap including the air in the inter-filter isolation unit has an outer shape defined by surrounding a side surface and an upper surface with an insulating material.
(16) The imaging device according to (15), in which
   the gap of the inter-filter isolation unit is provided to extend to an inside of the semiconductor substrate, and the pixel isolation unit is provided below the gap.
(17) The imaging device according to any one of (10) to (16), in which a gap is provided inside the sub-pixel isolation unit.
(18) The imaging device according to any one of (10) to (17), in which
   the pixels each include two of the sub-pixels, and
   the sub-pixel isolation unit separates the photoelectric conversion unit for each of the sub-pixels by extending in one direction.
(19) The imaging device according to any one of (10) to (17), in which
   the pixels each include four of the sub-pixels, and
   the sub-pixel isolation unit separates the photoelectric conversion unit for each of the sub-pixels by extending in each of one direction and a direction orthogonal to the one direction.
(20) An electronic device including an imaging device, in which
   the imaging device includes
   a semiconductor substrate including a photoelectric conversion unit provided for each of pixels arranged two-dimensionally and a pixel isolation unit that isolates the photoelectric conversion units from each other;
   a color filter and an on-chip lens provided for each of the pixels on one surface of the semiconductor substrate;
   an inter-filter isolation unit provided to include a low refractive index material having a refractive index lower than a refractive index of the color filter between the color filters and isolate the color filter for each of the pixels; and
   a sub-pixel isolation unit that isolates the photoelectric conversion units of the pixels including a plurality of sub-pixels for each of the sub-pixels.

### REFERENCE SIGNS LIST

- 1: Imaging device
- 12: Pixel
- 13, 13A, 13B, 13C, 13D: Pixel unit
- 110: Semiconductor substrate
- 111: Photoelectric conversion unit
- 112: Pixel isolation unit
- 113: Light shielding unit
- 114: Sub-pixel isolation unit
- 115: Low refractive index region
- 116: Gap
- 122: Dielectric layer
- 123: Reflection control layer
- 124: Fixed charge layer
- 130: Color filter
- 131: Contour portion
- 140: Inter-filter isolation unit
- 141: Insulating layer
- 151: On-chip lens
- 152: Antireflection film

## Claims

1. An imaging device comprising:
a semiconductor substrate including a photoelectric conversion unit provided for each of pixels arranged two-dimensionally and a pixel isolation unit that isolates the photoelectric conversion units from each other;
a color filter and an on-chip lens provided for each of the pixels on one surface of the semiconductor substrate;
an inter-filter isolation unit provided to include a low refractive index material having a refractive index lower than a refractive index of the color filter between the color filters and isolate the color filter for each of the pixels; and
a sub-pixel isolation unit that isolates the photoelectric conversion units of the pixels including a plurality of sub-pixels for each of the sub-pixels.

2. The imaging device according to claim 1, wherein
the pixels each include two of the sub-pixels, and
the sub-pixel isolation unit separates the photoelectric conversion unit for each of the sub-pixels by extending in one direction.

3. The imaging device according to claim 2, wherein the sub-pixel isolation unit is divided into two portions separated from each other by being divided at a central portion of the pixel.

4. The imaging device according to claim 2, wherein the sub-pixel isolation unit is provided in an island shape in the pixel.

5. The imaging device according to claim 2, wherein a light shielding unit is provided on a side of the one surface of the pixel isolation unit.

6. The imaging device according to claim 2, wherein the sub-pixel isolation unit is provided continuously between the pixels adjacent to each other across the pixel isolation unit between the pixels adjacent in the one direction.

7. The imaging device according to claim 2, wherein the sub-pixel isolation unit is provided to penetrate the semiconductor substrate.

8. The imaging device according to claim 7, wherein the sub-pixel isolation unit is divided into two portions separated from each other by being divided in a thickness direction of the semiconductor substrate.

9. The imaging device according to claim 2, wherein
the low refractive index material is air, and
the inter-filter isolation unit includes a gap including the air and an insulating material covering at least a part of an inner wall of the gap.

10. The imaging device according to claim 1, wherein a low refractive index region having a refractive index lower than a refractive index of the color filter is provided inside the color filter on a side of the semiconductor substrate.

11. The imaging device according to claim 10, wherein the low refractive index region is provided to extend from a bottom surface of the color filter on the side of the semiconductor substrate to a central portion of the color filter.

12. The imaging device according to claim 10, wherein the low refractive index region is provided in a region corresponding to the sub-pixel isolation unit.

13. The imaging device according to claim 12, wherein the low refractive index region is provided in an island shape in the pixel.

14. The imaging device according to claim 12, wherein the low refractive index region is divided into a plurality of portions separated from each other by being divided at a central portion of the pixel.

15. The imaging device according to claim 10, wherein
the low refractive index material is air, and
a gap including the air in the inter-filter isolation unit has an outer shape defined by surrounding a side surface and an upper surface with an insulating material.

16. The imaging device according to claim 15, wherein
the gap of the inter-filter isolation unit is provided to extend to an inside of the semiconductor substrate, and the pixel isolation unit is provided below the gap.

17. The imaging device according to claim 10, wherein a gap is provided inside the sub-pixel isolation unit.

18. The imaging device according to claim 10, wherein
the pixels each include two of the sub-pixels, and
the sub-pixel isolation unit separates the photoelectric conversion unit for each of the sub-pixels by extending in one direction.

19. The imaging device according to claim 10, wherein
the pixels each include four of the sub-pixels, and
the sub-pixel isolation unit separates the photoelectric conversion unit for each of the sub-pixels by extending in each of one direction and a direction orthogonal to the one direction.

20. An electronic device comprising an imaging device, wherein
the imaging device includes:
a semiconductor substrate including a photoelectric conversion unit provided for each of pixels arranged two-dimensionally and a pixel isolation unit that isolates the photoelectric conversion units from each other;
a color filter and an on-chip lens provided for each of the pixels on one surface of the semiconductor substrate;
an inter-filter isolation unit provided to include a low refractive index material having a refractive index lower than a refractive index of the color filter between the color filters and isolate the color filter for each of the pixels; and
a sub-pixel isolation unit that isolates the photoelectric conversion units of the pixels including a plurality of sub-pixels for each of the sub-pixels.
